# EUROPEAN PATENT SPECIFICATION

(11) **EP 0 676 669 B1**
(45) Date of publication and mention of the grant of the patent: **18.06.1997**
(21) Application number: 95103146.7
(22) Date of filing: 06.03.1995
(51) Int. Cl.: G03F 7/033, H05K 3/28

(54) **Pliable, aqueous processable, photoimageable permanent coatings for printed circuits**
Flexible, wäsrigentwickelbare, durch Licht abbildbare, dauerhafte Überzugsmittel für gedruckte Schaltungen
Revêtements permanents flexibles, pouvant être photostructurés et developpés en milieu aqueux pour circuits imprimés

(30) Priority: 07.04.1994 US 224369
(43) Date of publication of application: 11.10.1995
(73) Proprietor: E.I. DU PONT DE NEMOURS AND COMPANY, Wilmington Delaware 19898 (US)
(72) Inventor: Dueber, Thomas Eugene, Wilmington, Delaware 19803 (US); Schadt III, Frank Leonard, Wilmington, Delaware 19806 (US)
(74) Representative: von Kreisler, Alek, Dipl.-Chem.

(56) References cited:
- WO-A-93/17368

## Description

### BACKGROUND OF THE INVENTION

The present invention is directed to aqueous processable, photopolymerizable compositions having superior flexibility while preserving important properties for their use as permanent coatings for the protection of printed circuitry.

Photopolymerizable resist materials are known, for example, from U.S. Patent Nos. 3,469,982 and 3,547,730, which describe a film resist with a sandwich structure in the form of a photopolymerizable layer between a cover sheet and a temporary support. This film resist can, for instance, be laminated on a copper base, exposed imagewise and developed with organic solvents or aqueous solutions, whereby a defined resist layer is formed. Typically the copper base for a printed circuit board is rigid, with limited flexibility of just a few degrees, such as the conventional copper-clad fiberglass epoxy laminates. More recently, printed circuits are being prepared on highly flexible film substrates to form electronic packages which may be folded and refolded one or more times to fit a specified configuration or a dynamic mechanical operation.

The defined resist layer thus produced can now be selectively etched, electroplated or treated with solder on the substrate. Particularly high demands are placed on photoresist films if they are used as permanent coatings that function as solder resists or masks. In this case, the developed, photopolymerized layer must withstand temperatures up to 300°C without degradation, loss of adhesion or accumulation of residues contained in or on the molten solder. With the advanced technology of today's printed circuit boards, it is important to have the capability to photoimage a solder mask. According to the current state of the art, such solder masks can be made by spraying, coating or calendaring liquid compositions on a substrate or also by laminating a dry film on a substrate.

Due to the adverse environmental impact of solvents, aqueous developable photopolymer systems with fast development are now preferred. The use of photopolymer resists with acid functions, primarily carboxyl functions, is known to impart aqueous processability. However, these groups are disadvantageous in many subsequent steps or events. In the case of photoresists, delamination of the resist is observed in alkali etching or gold plating and, in the case of solder masks, inadequate environmental resistance can occur. Modification of the carboxyl groups with melamine formaldehyde compounds to overcome the named disadvantages is known (EP 01 15 354 and U.S. Patent No. 4,247,621).

The utilization of polymers containing carboxylic acid groups that are subsequently converted to less reactive and less moisture sensitive species is also known. U.S. Patent 4,987,054 discloses a photopolymerizable formulation yielding improved properties containing an acid copolymeric binder wherein a copolymer structural unit is the half acid/amide of a dicarboxylic acid. The disclosed formulations are used with conventional rigid printed circuit boards, processed with wholly aqueous alkaline solutions and are storage stable. European Patent Application EP 430,175 discloses a photopolymeric system similar to U.S. 4,987,054. Further WO 93/17368 discloses an aqueous processable, photopolymerizable, permanent coating composition, that is pliable and can withstand molten solder after cure, which comprises:
(a) at least one copolymeric binder containing at least one structural unit A and at least one additional structural unit B1 or B2 containing carboxyl groups, wherein:
   (I) 5 to 50 percent by weight of the copolymer is formed from at least one different structural unit B₁, B₂ or combinations thereof containing carboxyl groups,
   (II) 50 to 95 percent by weight of the copolymer is formed from structural unit A, wherein A is different from structural units B₁ and B₂,
   (III) A, B₁ and B₂ have the structures: 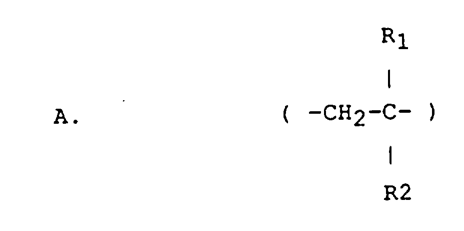 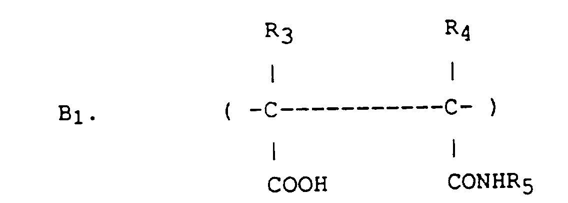 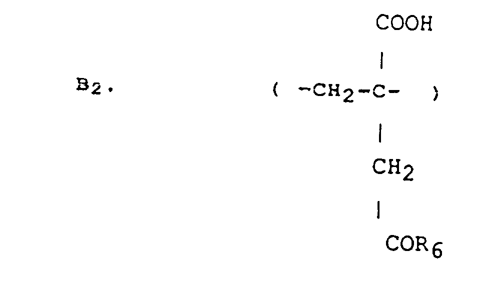 in which:
      R₁ is H, alkyl, phenyl and alkylphenyl;
      R₂ is H, CH₃, phenyl, -COOR₇, -CONR₈R₉ and -CN; R₃ and R₄ independently are H and alkyl;
      R₅ is alkyl or aryl which is unsubstituted or substituted with primary amino, secondary amino, tertiary amino, hydroxy or ether groups or mixtures thereof;
      R₆ is -OH and NHR₅;
      R_{7,} R₈ and R₉ independently are H, alkyl and aryl, which is unsubstituted or substituted with one or more hydroxy, ester, keto, ether or thioether groups.
(b) a monomeric component which is an acrylated urethane;
(c) a photoinitiator or a photoiniator system; and
(d) a thermal crosslinking agent.

As the electronic industry is driven towards faster, more reliable and compact devices, there is an increasing need in the printed circuit field for a more pliable, permanent coating that can withstand typical manufacturing process conditions, such as molten solder, and continuously varying environmental conditions while maintaining its integrity. The capability of such a coating to stand up to varied conditions and, in addition, be photoimageable and aqueous processable would constitute an advancement of the art. Current protective coatings for polyimide flexible circuitry require mechanical punching or drilling before lamination in an overall costly, low productivity process. Particularly preferred is a photoimageable, aqueous processable, permanent coating for use with flexible circuitry that can be made with conventional, lower cost photoforming manufacturing processes that have higher resolution capability, and wherein the flexible circuits can be subjected to flexural stress and yet maintain functionality.

### SUMMARY OF THE INVENTION

The present invention relates to an aqueous processable, photopolymerizable, permanent coating composition, that is both pliable and withstands molten solder after cure, which comprises:
a) a cobinder system comprising an admixture of at least one low molecular weight copolymer binder having a molecular weight in the range of from 2,000 to 10,000, which is the reaction product of a primary amine with a copolymer formed from at least one ethylenically unsaturated dicarboxylic acid anhydride and at least one ethylenically unsaturated comonomer and containing at least one structural unit A and at least one additional structural unit B₁ or B₂ containing carboxyl groups; and at least one high molecular weight carboxylic acid-containing copolymer binder having a molecular weight in the range of from 50,000 to 500,000, wherein:
   (I) 5 to 50 percent by weight of said low molecular weight copolymer binder is formed from at least one structural unit B₁, B₂ or combinations thereof containing carboxyl groups,
   (II) 50 to 95 percent by weight of said low molecular weight copolymer binder is formed from structural unit A, wherein A is different from structural units B₁ and B₂,
   (III) A, B₁ and B₂ have the structures: 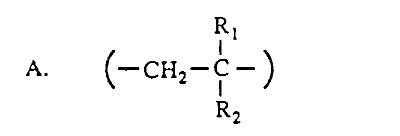 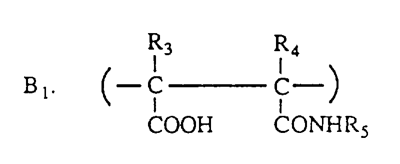 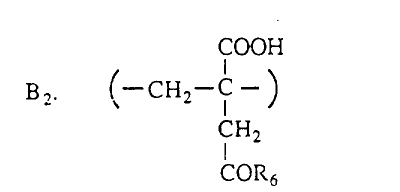
   wherein:
   R₁ is H, alkyl, phenyl or aryl;
   R₂ is H, CH₃, phenyl, aryl, -COOR₇, -CONR₈R₉ or -CN;
   R₃ and R₄ independently are H or alkyl;
   R₅ is alkyl or aryl which is unsubstituted or substituted with primary amino, secondary amino, tertiary amino, hydroxy or ether groups or mixtures thereof;
   R₆ is -OH or -NHR₅; and
   R₇, R₈ and R₉ independently are H, alkyl or aryl, which is unsubstituted or substituted with one or more hydroxy, ester, keto, ether or thioether groups;
b) an acrylated urethane monomeric component;
c) a photoinitiator or a photoinitiator system; and
d) a blocked polyisocyanate crosslinking agent.

### DETAILED DESCRIPTION OF THE INVENTION

The present invention relates to an aqueous processable, permanent, photopolymerizable composition for use as a pliable protective coating for flexible circuitry comprising as essential ingredients (a) a cobinder system, (b) an acrylated urethane monomeric component, (c) a photoinitiator or a photoinitiator system and (d) a blocked polyisocyanate cross-linking agent as specifically described hereinafter.

### (a) Cobinder System

The cobinder system essential to the invention contains a low molecular weight copolymer binder component formed from 50 to 95% by weight of at least one structural unit A and from 5 to 50% by weight of at least one additional structural unit B₁ or B₂ containing carboxyl groups, wherein A, B₁ and B₂ have the structures: 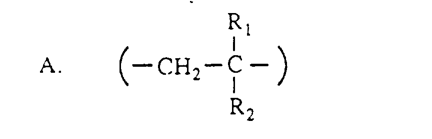 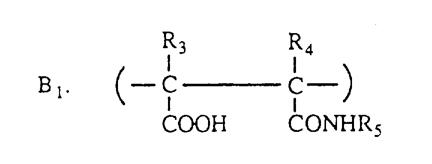 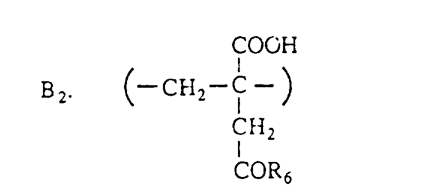 wherein:
R₁ is H, alkyl, phenyl or aryl, preferably H or CH₃;
R₂ is H, CH₃, phenyl, aryl, -COOR₇, -CONR₈R₉ or -CN, preferably phenyl, -COOR7 or -CONRBR₉;
R₃ and R₄ independently are H or alkyl;
R₅ is alkyl or aryl which is unsubstituted or substituted with primary amino, secondary amino, tertiary amino, hydroxy or ether groups or mixtures thereof;
R₆ is -OH or -NHR₅; and
R₇, R₈ and R₉ independently are H, alkyl or aryl, which is unsubstituted or substituted with one or more hydroxy, ester, keto, ether or thioether groups, preferably unsubstituted or hydroxy substituted alkyl or aryl groups.

The proportion of structural unit A ranges from 50 to 95 percent by weight, preferably from 65 to 90 percent by weight, and the proportion of structural unit B₁ and/or B₂ ranges from 5 to 50 percent by weight, preferably from 10 to 35 percent by weight. It is understood that these percentages exclude the terminal portions of the binder.

The low molecular weight copolymer binder containing adjacent carboxyl and amide groups can be formed by direct copolymerization of one or more ethylenically unsaturated dicarboxylic acids, which, after dehydration, form structural units B₁ and/or B₂, with one or more comonomers which form structural unit A, followed by reaction of primary amines or anhydrous ammonia with the resultant copolymers that are formed by the copolymerization. Suitable ethylenically unsaturated dicarboxylic acid anhydrides which form structural units B₁ and/or B₂ are, for example, maleic acid anhydride, itaconic acid anhydride and citraconic acid anhydride. The proportion of ethylenically unsaturated dicarboxylic acid anhydrides in the copolymer binder ranges from 5 to 50 percent by weight, preferably from 10 to 35 percent by weight.

Primary aliphatic or aromatic, optionally substituted amines can be used in the invention. Substituents can be the following functional groups: primary amino, secondary amino, tertiary amino, hydroxy, ester, keto, ether and/or thioether groups. Propylamine, butylamine, octylamine, aminopropanol, aminoethanol, aminophenol, 1,2-diaminoethane, 1,3-diaminopropane, 1,3-diaminopentane, N-methyl-1,2-diaminoethane, N-ethyl-1,2-diaminoethane, N,N-dimethyl-1,2-diaminoethane or N-(2-hydroxyethyl)-1,2-diaminoethane are preferred.

Suitable comonomers, which form the structural unit A of the copolymer binder, are styrene, substituted styrenes, and unsaturated carboxylic acids and their derivatives, such as, for example, (meth)acrylic acid, (meth)acrylic acid amides and (meth)acrylates. Methyl methacrylate, methyl acrylate, acrylamide, ethyl acrylate, butyl (meth)acrylate, and styrene are preferred.

The amic acid of the copolymer binder derived from the ethylenically unsaturated dicarboxylic acid anhydride has a molecular weight in the range of from 2,000 to 10,000, preferably from 3,000 to 6,000. The preferred molecular weight range can be influenced by the use of an aliphatic amine that contains primary, secondary or tertiary amino substitution which leads to lower solubility resins at the higher end of the molecular weight range.

When the permanent coating is photoprinted, development of the composition requires that the copolymer binder material contains sufficient acidic or other groups to render the composition processable in aqueous alkaline developer. The coating layer formed from the composition is removed in portions which are not exposed to radiation but is substantially unaffected in exposed portions during development by aqueous alkaline liquids such as wholly aqueous solutions containing 1% sodium or potassium carbonate by weight for a time period of five minutes at a temperature of 40°C.

The permanent coating composition of the invention additionally contains at least one high molecular weight carboxylic acid-containing copolymer binder component to modify coated film integrity, adhesion, hardness, oxygen permeability, moisture sensitivity and other mechanical or chemical properties required during its processing or end use. Suitable high molecular weight copolymer cobinders, which are used in combination with the low molecular weight copolymer binder component, include as comonomers: 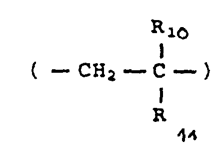 wherein R₁₀ is H, alkyl, -CN, phenyl or alkylphenyl; R₁₁ is phenyl, alkylphenyl or -CO₂R₁₂ and R₁₂ is H or alkyl. Preferred comonomers for use in the cobinder are styrene, (meth)acrylic acid and methyl, ethyl and butyl(meth)acrylate. (Meth)acrylic acid is an especially preferred comonomer in the cobinder for aqueous alkaline development. Other suitable high molecular weight carboxylic acid-containing copolymer binders are those comprising styrene and maleic anhydride/acid/halfester/ester/half-amide, and substituted analogues thereof.

The proportion of the low molecular weight copolymer binder component containing adjacent carboxyl and amide groups ranges from 5 to 50 weight % and the proportion of the high molecular weight carboxylic acid copolymer binder component ranges from 50 to 95 weight %, based on the total weight of the cobinder system.

A preferred cobinder system comprises an admixture of from 2,000 to 10,000 low molecular weight resin of a reaction product of a primary amine with a copolymer formed from at least one ethylenically unsaturated dicarboxylic acid anhydride and at least one ethylenically unsaturated comonomer, and from 50,000 to 500,000 high molecular weight carboxylic acid-containing copolymer.

### (b) Acrylated Urethane Monomeric Component

An acrylated urethane is an essential component of the photopolymerizable composition, since it imparts increased flexibility to the cured layer and reduced brittleness, when used in the correct proportion with the other essential ingredients of the invention. It is known that many factors influence the properties (e.g. glass transition temperature) and thus performance of urethane structures in a particular application. These factors include diisocyanate type, diol type (i.e. polyester, polyesteramide, polyether), diol molecular weight, codiols (i.e. short chain diols), ratio of diol to codiol, as well as the amount of branching and molecular weight of the resultant polyurethane. Properties after acrylation will vary correspondingly. It is important to choose the proper acrylated urethane and amount of such relative to the other essential ingredients in order to obtain a proper balance of flexibility, toughness and chemical resistance in the permanent coating. The acrylated urethane is present in an amount of from 5 to 30 parts by weight and contains at least one acrylate or methacrylate group.

Preferred types of acrylated urethanes have the general formula: 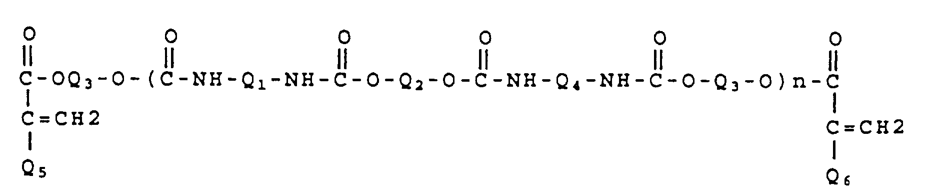 wherein Q₁ and Q₄ are aromatic groups which may be unsubstituted or substituted by lower alkyl groups and which can contain a lower alkylene group as a connecting member; Q₂ and Q₃ are independently polyoxyalkylene containing 1 to 10 carbon atoms; Q₅ and Q₆ are independently alkyl of 1 to 3 carbon atoms or H, and n is at least one.

Particularly preferred herein is a urethane diacrylate which is the reaction product of toluene diisocyanate with a polyol with the end isocyanate groups end-capped with hydroxyethyl acrylate.

The acrylated urethane may also include diacrylates and triacrylates which are carboxylated to provide acid numbers ranging from 1 to 50 or more and molecular weights ranging from 500 to 5000. Carboxylated urethane diacrylates and triacrylates are particularly advantageous since they provide cleaner development in aqueous basic developer.

Suitable comonomers which can be used in combination with the acrylated urethane include the following: 1,5-pentanediol diacrylate, diethylene glycol diacrylate, hexamethylene glycol diacrylate, 1,3-propanediol diacrylate, decamethylene glycol diacrylate, decamethylene glycol dimethacrylate, 1,4-cyclohexanediol diacrylate, 2,2-dimethylol-propane diacrylate, glycerol diacrylate, tripropylene glycol diacrylate, glycerol triacrylate, trimethylolpropane triacrylate, pentaerythritol triacrylate, polyoxyethylated trimethylolpropane triacrylate and trimethacrylate and similar compounds as disclosed in U.S. Patent 3,380,831, 2,2-di(p-hydroxyphenyl)-propane diacrylate, pentaerythritol tetraacrylate, 2,2-di-(p hydroxyphenyl)-propane dimethacrylate, triethylene glycol diacrylate, polyoxyethyl-2,2-di-(p-hydroxyphenyl)-propane dimethacrylate, di-(3-methacryloxy-2-hydroxypropyl)ether of bisphenol-A, di-(2-methacryloxyethyl) ether of bisphenol-A, di-(3-acryloxy-2-hydroxypropyl) ether of bisphenol-A, di-(2- acryloxyethyl) ether of bisphenol-A, di-(3-methacryloxy-2-hydroxypropyl) ether of tetrachloro-bisphenol-A, di-(2-methacryloxyethyl) ether of tetrachloro-bisphenol-A, di-(3-methacryloxy-2-hydroxypropyl) ether of tetrabromo-bisphenol-A, di-(2-methacryloxyethyl) ether of tetrabromo-bisphenol-A, di-(3-methacryloxy-2-hydroxypropyl) ether of 1,4-butanediol, triethylene glycol dimethacrylate, trimethylol propane triacrylate, ethylene glycol dimethacrylate, butylene glycol dimethacrylate, 1,3-propanediol dimethacrylate, 1,2,4- butanetriol trimethacrylate, 2,2,4-trimethyl-1,3-pentanediol dimethacrylate, pentaerythritol trimethacrylate, 1-phenyl ethylene-1,2-dimethacrylate, pentaerythritol tetramethacrylate, trimethylol propane trimethacrylate, 1,5-pentanediol dimethacrylate, 1,4- benzenediol dimethacrylate, and 1,3,5-triisopropenyl benzene and polycaprolactone diacrylate. Excessive amounts of trifunctional acrylate monomers can result in reduction of required flexibility.

A particularly preferred class of comonomers is hydroxy C₁-C₁₀-alkyl acrylate, hexamethylene glycol diacrylate, triethylene glycol diacrylate, tripropylene glycol diacrylate, pentaerythritol triacrylate, trimethylolpropane triacrylate, polyoxyethylated trimethylolpropane triacrylate, di-(3-acryloxy-2-hydroxypropyl) ether of bisphenol-A, di-(3-acryloxy-2-hydroxypropyl) ether of tetrabromo-bisphenol-A, or methacrylate analogues thereof.

### (c) Photoinitiator System

The photoinitiator system contains one or more initiator compounds that directly furnish free-radicals when activated by actinic radiation. The system also may contain a sensitizer that is activated by the actinic radiation, causing the initiator compound to furnish the free-radicals. The sensitizer may extend spectral response into the near ultraviolet, visible, and near infrared spectral regions.

Numerous conventional photoinitiator systems are known to those skilled in the art and may be used herein provided they are compatible with the other ingredients of the coating composition. A large number of free-radical generating compounds, including redox systems such as Rose Bengal/2-dibutylaminothanol, may be selected to advantage. A useful discussion of dye sensitized photopolymerization can be found in "Dye Sensitized Photopolymerization" by D. F. Eaton in Adv. in Photochemistry, Vol. 13, D. H. Volman, G. S. Hammond, and K. Gollinick, eds., Wiley-Interscience, New York, 1986, pp. 427-487.

Sensitizers useful with photoinitiators include methylene blue and those disclosed in U.S. Patents 3,554,753; 3,563,750; 3,563,751; 3,647,467; 3,652,275; 4,162,162; 4,268,667; 4,351,893; 4,454,218; 4,535,052; and 4,565,769. A preferred group of sensitizers include the bis(p-dialkylaminobenzylidene) ketones disclosed in Baum et al, U.S. Patent 3,652,275, and the arylidene aryl ketones disclosed in Dueber, U.S. Patent 4,162,162.

Preferred photoinitiator systems are 2,4,5-triphenylimidazolyl dimers in combination with chain transfer agents, or hydrogen donors, such as are disclosed in U.S. Patents 3,479,185; 3,784,557; 4,311,783; and 4,622,286.

Preferred hexaarylbiimidazoles (HABI) are 2-o-chlorosubstituted hexaphenylbiimidazoles in which the other positions on the phenyl radicals are unsubstituted or substituted with chloro, methyl or methoxy. The most preferred initiator is o-Cl-HABI, i.e., 1,1'-biimidazole, 2,2'-bis(o-chlorophenyl)-4,4',5,5'-tetraphenylimidazole dimer.

Hydrogen donor compounds that function as chain transfer agents in the photopolymer compositions include: 2-mercaptobenzoxazole, 2-mercaptobenzothiazole and 4-methyl-4H- 1,2,4-triazole-3-thiol; as well as various types of compounds, e.g., (a) ethers, (b) esters, (c) alcohols, (d) compounds containing allylic or benzylic hydrogen, (e) acetals, (f) aldehydes, and (g) amides disclosed in column 12, lines 18 to 58 of MacLachlan U.S. Patent 3,390,996. Suitable hydrogen donor compounds for use in systems containing both biimidazole type initiator and N-vinyl carbazole are 5-chloro-2-mercaptobenzothiazole; 2- mercaptobenzothiazole; 1H-1,2,4-triazole-3-thiol; 6-ethoxy-2- mercaptobenzothiazole; 4-methyl-4H-1,2,4-triazole-3-thiol; 1-dodecanethiol; and mixtures thereof.

A particularly preferred class of photoinitiators and photosensitizers are benzophenone, Michler's ketone, ethyl Michler's ketone, p-dialkylaminobenzaldehydes, p-dialkylaminobenzoate alkyl esters, polynuclear quinones, thioxanthones, hexaarylbiimidazoles, cyclohexadienones, benzoin, benzoin dialkyl ethers, or combinations thereof where alkyl contains 1 to 4 carbon atoms.

### (d) Blocked Polyisocyanate Crosslinking Agent

The photopolymerizable compositions of the present invention are generally applied to a substrate by lamination or from solution. In these processes, the composition is heated, for example, during the lamination operation or during evaporation of the solvent after application from solution. Partial crosslinking can take place in the unexposed areas even before photostructuring, which results in impairment of image quality. Thus, a desirable property of the photopolymerizable composition is that it undergoes as little crosslinking as possible due to this heat treatment. On the other hand, it is also desirable that the composition be cured rapidly and at moderate temperatures after application and imagewise exposure in order to obtain high throughput and simultaneous savings of energy costs.

According to the present invention, a thermally activated crosslinking agent is used which crosslinks with the reactive functional groups, such as hydroxyl, carboxyl, amide and amine groups which are present in the copolymer binder components and other ingredients in the photoimageable coating composition. The presence of the proper crosslink imparts the capability to withstand molten solder temperature and improves chemical resistance or other mechanical or chemical properties required in the end-use product.

The preferred crosslinking agent used herein is a blocked polyisocyanate which has a cleavage temperature of at least 100°C, or a mixture of polyisocyanates of this type. In the context of this description, this is to be understood as meaning a blocked polyisocyanate in which at least half of the blocked isocyanate groups are deblocked at a temperature of at least 100°C and are thereby available for reaction with the isocyanate-reactive functional groups of the other components of the photoimageable composition.

The polyisocyanate on which the blocked component is based may be any aliphatic, cycloaliphatic, aromatic or arylaliphatic compounds having at least two, preferably two to four, isocyanate groups and which may have further substituents which are inert to isocyanate groups, such as alkyl or alkoxy groups.

These include, for example, the following compounds: 2,4-diisocyanatotoluene, and technical grade mixtures thereof with 2,6-diisocyanatotoluene, 1,5-diisocyanatonaphthalene, 1,4-diisocyanatonaphthalene, 4,4'-diisocyanatodiphenylmethane and technical grade mixtures of various diisocyanatodiphenylmethanes (for example the 4,4'-and 2,4'-isomers), diisocyanato-m-xylylene, N,N'-di(4-methyl-3-isocyanatophenyl)urea, 1,6-diisocyanatohexane, 1,12-diisocyanatododecane, 3,3,5-trimethyl-1-isocyanatomethylcyclohexane(isophorone diisocyanate), trimethyl-1,6-diisocyanatohexane, 1-methyl-2, 4-diisocyanatocyclohexane, trisisocyanatotriphenyl-methane and 4,4'-diisocyanatodicyclohexylmethane.

The polyisocyanates may be blocked by various radicals. Examples of suitable blocking components are beta-dicarbonyl compounds, such as malonates, acetoacetates or 2,4-pentanedione, or hydroxamates, triazoles, imidazoles, tetrahydropyrimidines, lactams, oximes, ketoximes, low molecular weight alcohols, or phenols or thiophenols.

The blocked polyisocyanate may also be a urethanized, carbodiimidated, biuretized, or dimerized or trimerized polyisocyanate, a trimer containing an isocyanurate ring, a biscyclic urea compound, a polymeric isocyanate, a copolymer of two or more diisocyanates, or other forms of polyisocyanates which are inactive below 100°C, so long as their cleavage temperature is at least 100°C. Examples of these are urethanized 4,4'-diisocyanato-diphenylmethane, carbodiimidated 4,4'-diisocyanatodiphenylmethane, uretdione of 2,4-diisocyanatotoluene, the trimer of diisocyanatotoluene, N,N',N''-tri(6-isocyanatohexyl)biuret, isophorone diisocyanate, trimeric hexane diisocyanates, trimeric dodecane diisocyanates, adipoyl bis(propylene urea), and azelaoyl bis(propylene urea).

Preferred blocked polyisocyanates have a cleavage temperature between 100°C to 200°C. Particularly preferred herein are methylethyl ketoxime blocked 1,6-diisocyanatohexane trimers and methylethyl ketoxime blocked isophorone diisocyanate.

Compared with photopolymerizable compositions cured using melamine-formaldehyde crosslinking agents, the photopolymerizable coating compositions of the invention are distinguished, surprisingly, by higher elongation and better chemical resistance at lower cure temperature. In addition, the cured coatings maintain their flexibility after cure, whereas coatings using melamine-formaldehyde crosslinking agents require a 20°C higher cure temperature to obtain the same flex stability after cure, and sometimes lose some of this flexibility while aging under cool and/or dry conditions. To maintain stability of the laminate material, the cure temperature should be as low as possible above 100°C, since flexible circuits undergo more distortion at higher cure temperatures.

### Fillers

The aqueous processable, photopolymerizable permanent coating compositions of this invention may optionally contain a preformed macromolecular elastomeric component as an organic filler. This elastomeric component typically is present as a separate micro-phase in the aqueous processable permanent coating composition, and as such is believed to be functioning as an elastomeric filler for the composition. Typically, such organic components contain substantially no acidic groups and consequently are insoluble in aqueous, alkaline developer solutions. However, dispersibility in the permanent coating composition and aqueous, alkaline developer solutions may be improved by incorporating sufficient carboxylic acid groups into the organic filler component if improvement in such development is required.

Although many elastomers may be used in the permanent coating composition, poly(methyl methacrylate-co-butadiene-co-styrene) is preferred. Other organic fillers which may be used include synthetic flexible polymers and rubbers, e.g., butadiene-co-acrylonitrile, acrylonitrile-co-butadiene-co-styrene, methacrylate-co-acrylonitrile-co-butadiene-co-styrene copolymers, and styrene-co-butadiene-co-styrene, styrene-co-isoprene-co-styrene block copolymers; saturated polyurethanes; and poly(methylmethacrylate-co-butylacrylate). Further examples of organic filler components include conventional elastomers as defined on page 232 of "Hackh's Chemical Dictionary" Fourth Edition, Edited by J. Grant, McGraw-Hill Book Company, 1972.

The permanent coating compositions may also contain other organic fillers or inorganic particulates to modify the mechanical or chemical properties required during processing or end use. Suitable fillers include organic or inorganic reinforcing agents which are essentially transparent as disclosed in U.S. Patent 2,760,863, e.g., organophilic silica bentonite, silica, and powdered glass having a particle size less than 0.4 micrometer; inorganic thixotropic materials as disclosed in U.S. Patent 3,525,615 such as boehmite alumina, clay mixtures of highly thixotropic silicate oxide such as bentonite and finely divided thixotropic gel containing 99.5% silica with 0.5% mixed metallic oxide; microcrystalline thickeners as disclosed in U.S. Patent 3,754,920 such as microcrystalline cellulose and microcrystalline silicas, clays, alumina, bentonite, kalonites, attapultites, and montmorillonites; finely divided powders having a particle size of 0.5 to 10 micrometers as disclosed in U.S. Patent 3,891,441 such as silicon oxide, zinc oxide, and other commercially available pigments; and the binder-associated, transparent, inorganic particles as disclosed in EP-A-0 259 812 such as magnesium silicate (talc), aluminum silicate (clay), calcium carbonate and alumina. Typically, the filler is transparent to actinic radiation to preclude adverse effects during imaging exposure. Depending on its function in the photopolymerizable composition, the filler may be colloidal or have an average particle size of 0.5 micrometers or more in diameter.

### Adhesion Promotor

The permanent coating composition may also contain a heterocyclic or mercaptan compound to improve adhesion of the coating to the metal circuit pattern during processing or in the end-use product. Suitable adhesion promotors include heterocyclics such as those disclosed in Hurley et al, U.S. Patent 3,622,334, Jones, U.S. Patent 3,645,772, and Weed, U.S. Patent 4,710,262,

Preferred adhesion promoters include benzotriazole, 5-chloro-benzotriazole, 1-chlorobenzotriazole, 1-carboxy-benzotriazole, 1-hydroxybenzotriazole, 2-mercapto benzoxazole, 1H-1,2,4-triazole-3-thiol, 5-amino-1,3,4-thiadiazole-2-thiol, and mercapto-benzimidazole.

### Other Components

Other compounds conventionally added to photopolymer compositions may also be present in the permanent coating to modify the physical properties of the film. Such components include: thermal stabilizers, colorants such as dyes and pigments, coating aids, wetting agents and release agents.

Thermal polymerization inhibitors that can be used in the permanent coating compositions are: Irganox® 1010, p-methoxyphenol, hydroquinone, and alkyl and aryl-substituted hydroquinones and quinones, cert-butyl catechol, pyrogallol, copper resinate, naphthylamines, beta-naphthol, cuprous chloride, 2,6-di-tert-butyl-p-cresol, phenothiazine, p-toluquinone and chloranil. Also useful as thermal polymerization inhibitors are the nitroso compounds disclosed in U.S. 4,168,982.

Various dyes and pigments may be added to increase the visibility of the resist image. Any colorant used, however, should preferably be transparent to the actinic radiation used.

On the basis of the essential ingredients (a) a cobinder system containing a copolymer component having amine-reacted anhydride functionality and a carboxylic acid-containing copolymer; (b) acrylated urethane; (c) photoinitiator system; and (d) blocked polyisocyanate crosslinking agent, a suitable concentration is component (a) present in an amount of 20 to 80 parts by weight, component (b) present in an amount of 10 to 40 parts by weight, component (c) present in an amount of 0.5 to 10 parts by weight, and component (d) present in an amount of 2 to 25 parts by weight.

### Permanent Coating Applications

The permanent coatings of the invention can be used as a solder mask to protect printed circuits during subsequent processing, primarily solder operations, and/or from environmental effects during use. Permanent coatings also are used as intermediate insulative layers, with or without development, in the manufacture of multilayer printed circuits.

In practice, a photopolymerizable, permanent coating layer, typically between 10 and 125 micrometers (0.4 and 5 mils) thick, is applied to a printed circuit substrate which typically is a printed circuit relief pattern on a substrate that is semi-rigid, such as fiberglass reinforced epoxy, or on a flexible film substrate based on polyimide or polyester film. The applied photopolymerizable, permanent coating layer is then imagewise exposed to actinic radiation to harden or insolubilize exposed areas. Any unexposed areas are then completely removed typically with an alkaline, aqueous sodium or potassium carbonate developer solution which selectively dissolves, strips or otherwise disperses the unexposed areas without adversely affecting the integrity or adhesion of the exposed areas. The developed permanent resist image is first treated to further cure or harden it by baking at elevated temperatures, such as one hour at 150° C , by additional uniform exposure to actinic radiation or a combination thereof to produce a circuit board having a cured permanent resist layer covering all areas except pad or through-hole areas. Electrical components are then inserted into the through-holes or positioned on surface mount areas and soldered in place to form the packaged electrical component.

The photopolymerizable permanent coating may be applied to a printed circuit substrate either as a liquid, as a pre-formed dry film, or as a combination of a liquid and dry film.

### Coating Liquids

The photopolymerizable, permanent resist may be coated as a liquid onto the printed circuit substrate using any conventional coating process. The liquid may be a solution or a dispersion of the permanent coating composition wherein the solvent is removed subsequent to coating to form a dry, solid, coverlay layer which, subsequent to coating, is directly imaged or exposed to actinic radiation to form a hardened coverlay layer. The liquids may be roller-coated, spin-coated, screen-coated or printed as disclosed in Coombs supra, in DeForest supra, in Lipson et al., U.S. Patent 4,064,287, or in Oddi et al., U.S. Patent 4,376,815. The liquid, typically as a solution, may also be curtain coated as disclosed in Losert et al., U.S. Patent 4,230,793. In the instance where printed circuits are manufactured on a continuous web of film substrate, permanent coating liquid may be coated by any conventional web coating process.

### Dry Film Lamination

A pre-formed, dry-film, photopolymerizable permanent coating layer is applied from a multi-ply, transfer, coverlay element using the lamination process as described in Celeste, U.S. Patent 3,469,982. The multi-ply, permanent coating element comprises, in order, an actinic-radiation transparent, temporary support film, e.g., polyethylene terephthalate or silicon treated polyethylene terephthalate, a thin photo-polymerizable, permanent coating layer, and optionally a removable cover sheet, e.g., polyethylene or polypropylene, to protect the permanent coating element during storage. The photopolymerizable, permanent coating layer, is present in a range of thickness from 10 to 125 µm (0.4 to 5 mils) when used over printed circuit substrates. As described in Celeste supra, the cover sheet, if present, is first removed and the uncovered permanent coating surface is laminated to the pre-cleaned copper printed circuit surface of the substrate using heat and/or pressure, e.g., with a conventional hot-roll laminator. Although the laminate is typically imagewise exposed to actinic radiation through the temporary support film, in some instances, the temporary support may be removed before imaging to improve resolution and other such properties. In some instances permanent coating adhesion to the substrate can be improved by treating the substrate surface with a liquid at or just prior to lamination. The liquid may be insensitive to actinic radiation and may be a solution of adhesion promotors as disclosed in Jones, U.S. Patent 3,645,772, a solvent or swelling agent for the coverlay layer such as disclosed in Fickes, U.S. Patent 4,069,076, a non-solvent, such as disclosed in Cohen, U.S. Patent 4,405,394 and European Patent 0041639, Pilette et al., U.S. Patent 4,378,264, and Weiner et al., European Patent 0040842,or a liquid component of the permanent coating layer such as disclosed in Lau et al., U.S. Patent 4,698,294. The liquid in some instances may be photosensitive. Typically, when a dry film is laminated to a printed circuit substrate having a low circuit relief, measures must be taken to eliminate entrapped air, e.g., from around circuit lines. Entrapped air is eliminated by the vacuum lamination process of Friel U.S. Patent 4,127,436, by the grooved roll lamination process of Collier et al., U.S. Patent 4,071,367, or by using liquid treating agents as described in Fickes supra and Lau et al supra.

### Permanent Coating Evaluation

Printed circuits must withstand a variety of tests that are dependent on the application of the circuits, which, in turn, governs the type of material used as the circuit substrate. A stringent application is for flexible printed circuits which require a fold or bend for a particular space requirement, such as a camera or video cassette recorder (VCR), and may require the capability of surviving multiple bends, such as in a computer disc drive. In some applications a flexible circuit is combined with a rigid circuit to form a flex-rigid multilayer printed circuit. The end-use tests for flexible circuits thus focus on adhesion and the capability to withstand single or multiple bends. In addition, accelerated aging is a useful test to simulate the practical concern of film aging on standing at ambient conditions for an extended period of time. The accelerated aging by exposure of the film to heat and humidity is effective for identifying film components that may oxidize or otherwise degrade more quickly than others. The tests that are used to support the Examples in this application are described herein.

### Time To Clear

This test evaluates the retention time for adequately developing coverlay. Coverlay is laminated onto a rigid substrate, then timed when passed through 1% aqueous sodium carbonate developer (which should be at the same temperature as that used in actual processing, typically 41 °C (105°F)). The total "time to clear" is reported in seconds, beginning from the time the sample enters the developer and ending at the time at which the unexposed coverlay is washed off of the substrate.

### Photo Speed

This test evaluates the processability of coverlay. Coverlay is laminated onto a substrate, then is exposed to 500 mj/cm² UV through a 21-step Stouffer sensitivity photo pattern. After the sample is developed, the resulting step-wedge pattern is analyzed. Values are reported in a X-Y range, in which the X value is the last step in which no developer attack is noted, and Y is the last step containing coverlay.

### Encapsulation

This test evaluates the capability of coverlay to adequately protect the substrate. The substrate and coverlay chosen for this test should represent those used for end use. The substrate is typically a circuit pattern and is processed with the coverlay exactly as is done in actual manufacturing. After processing, the sample is evaluated using 10X magnification for any haloing and/or delaminations, which constitute a failure. In addition, the sample is cross-sectioned along the edge of a circuit line and evaluated using magnification to ensure that the coverlay adequately covers the area with no "soda-strawing" defects.

### Cross-Hatch (Adhesion)

The test is performed according to ASTM D-3359-79, Method B. Test substrates are selected to duplicate the material typically used for end use, and are processed to mirror actual processing. The test areas are a blank copper area and a blank adhesive area. Specimens are tested "after processing" as well as "after solder exposure" (which simulates solder exposure during PCB fabrication). Typical "after solder" specimens are floated in 288°C 60/40 tin/lead solder for 30 seconds. Residual solder is then removed before evaluation. All specimens are scored with a 10 blade Gardco blade, then the sample is rotated 90° and rescored so that a cross-hatch pattern comprised of 100 squares has been etched into the coverlay surface. Adhesive tape is applied and rubbed to ensure good contact, and then pulled away at a 90° angle in a smooth fluid motion. The sample is examined using 10X magnification for defects; typically delamination or microcracks. Pick off from the cutting blade of 1-2% is not considered a failure but >2% pickoff is a failed sample.

### Bend & Crease

The substrate to be used for this test is typically a MIT flexural endurance pattern. The substrate is typically the same type as that used in the actual product application, i.e., the thickness and type (copper, adhesive) and the photoimaging processing steps (pre-clean, lamination, cure, solder exposure) are duplicated so that the evaluation reflects a true simulation. Samples are bent and creased by hand 90° perpendicular to the lines and spaces in 10 different areas of each sample, then examined using 10X magnification for defects such as cracks or delaminations. Any reported defects constitute a failure. Samples are evaluated "after processing" or "after solder", in which case samples are floated, coverlay side up, in 288°C 60/40 tin/lead solder for 30 seconds, then cooled to room temperature and evaluated as described above.

### MIT Folding Flexural Endurance

This test measures the number of folds to failure of etched flexible printed wiring circuit patterns processed with the photoimageable coverlay. Samples for evaluation are typically MIT flex endurance patterns. The artwork for the test pattern has 1.02 mm (0.04 inch) wide traces on 2.03 mm (0.08 inch) centers meandering to make six tracks on a 12.7 cm x 12.7 cm (5 inch x 5 inch) specimen. The substrate to be used for this test is typically of the same type as that used in the actual product application, i.e. the same thickness and type (copper, adhesive). In addition, the photoimaging processing steps (pre-clean, lamination, cure, solder exposure) are duplicated so that the evaluation reflects a real-life representation. Flexural endurance is measured using a MIT Folding Endurance Tester. The specimen is attached to the apparatus so that the sample is flexed perpendicular to the circuit lines. A 500g weight is attached. The sample rotates back and forth, 135° in each direction, at a rate of 175 double bends per minute. The MIT Flexural Endurance Tester counts the flex repetitions until the sample is severed at the crease. The number of cycles registered on the counter is then recorded as the endurance factor for the material under test.

### Chemical Resistance

This test analyzes any degradation in coverlay film properties when exposed to chemicals used in the photoimaging processing steps. Coverlay is processed on a circuit-patterned substrate (circuitry and substrate used are of the same type as that found in actual use). Each sample is immersed for up to 20 minutes in a chemical typically used in processing. These chemicals include plating chemicals such as 10% NaOH, 10% HC1, 10% H₂SO₄ and cleaning solvents such as methyl ethyl ketone (MEK), trichloroethylene (TCE) and isopropanol (IPA). After immersion, each sample is examined using 10X magnification for defects such as delamination, wicking, embrittlement, or solvent attack. Any defects found are reported as failures.

### Pencil Hardness

This test analyzes changes in the hardness of the coverlay after exposure to Isopropanol (IPA). Coverlay is processed onto a blank substrate. After curing, the substrate is evaluated for pencil hardness using ASTM D-3363. The reported value is then compared with a substrate that was immersed in isopropanol for 10 minutes, blotted dry and evaluated using the same method.

### Elongation to Break and Young's Modulus

The coating is laminated on Teflon® sheet, exposed at 500 mj/ cm², developed at 41°C (105°F) for two times the time to develop non-imaged material, air dried and cured for one hour at 170°C. The samples are cut into one-half inch wide strips with a JDC precision Sample Cutter (Thwing-Albert Instrument Co.). Samples tested as unconditioned material are placed into a zip-lock bag until testing. Samples that are conditioned are placed in a nitrogen-purged 100°C oven, the temperature is held for one hour, and then the samples are allowed to slowly cool to room temperature over a three hour period. The samples are placed in a desiccator with dry magnesium sulfate, and held in this dry condition until tested on an Instron tester according to ASTM D-882-83 (Method A). The percent elongation and Young's modulus are computed from the stress-strain data using Instron software Series IX Automated Materials Testing System 1.02C.

### EXAMPLES

To further substantiate the invention, the examples below are provided. Concentration of monomer components are given as percent by weight. Materials used for the examples are:

### Co-Binders

- A. High MW copolymers Carboxylated copolymer #1: Copolymer of ethyl acrylate, methyl methacrylate and acrylic acid (32/58/10) having a Tg of 37°C, molecular weight of 200,000 and acid number of 80.
- Carboxylated copolymer #2: copolymer of ethyl acrylate, ethyl methacrylate and acrylate, acid (61.7/25.7/12.6) having a Tg of 70°C, molecular weight of 180,000 and acid number of 100.
- Carboxylated copolymer #3: Copolymer of methyl methacrylate, butyl acrylate and methacrylic acid (33.5/55/11.5) having a Tg of 40°C, molecular weight of 130,000, and acid number of 74.
- B. Low MW Amic Acid: Copolymer of styrene, butyl methacrylate, butyl acrylate and itaconic anhydride reacted with n-butylamine having a molecular weight of 4,000.

### Monomers

- A. Ebecryl® 3704: Diacrylate of bisphenol-A-diglycidyl ether from Radcure, Atlanta, GA.
- Ebecryl® 6700: Urethane diacrylate from Radcure, Atlanta, GA
- Purelast® 233: Carboxylated urethane triacrylate from Polymer Systems Corp., Orlando, FL
- Purelast® 290: Carboxylated urethane diacrylate from Polymer Systems Corp., Orlando, FL

### Thermal Crosslinking Agents

- Cymel® 1158: Butyl ether of dimer and trimers formed from the condensation of melamine and formaldehyde from American Cyanamide, Wayne, NJ
- Blocked isocyanate #1: Hexamethylene diisocyanate based polyisocyanate blocked with methyl ethyl ketoxime and dissolved at 75% solids in Aromatic 100®.
- Blocked isocyanate #2: Hexamethylene diisocyanate based polyisocyanate blocked with methyl ethyl ketoxime and dissolved in propylene glycol methyl ether acetate.
- Blocked isocyanate #3: Hexamethylene diisocyanate based polyisocyanate blocked with caprolactam and dissolved at 75% solids in propylene glycol methyl ether acetate.
- Blocked isocyanate #4: Isophorone diisocyanate blocked with methyl ethyl ketoxime and dissolved at 75% solids in propylene glycol methyl ether acetate.

### Initiators

- o-C1 HABI: Hexaarylbiimidazole
- EMK: Ethyl Michler's Ketone

### Adhesion Promoter

- 3MT: 3-mercapto-1H-1,2,4-triazole from Esprit Chemical Co., Rockland, MA

### Other Ingredients

- Irganox® 1010: Antioxidant from Ciba Geigy Corp., Ardsley, NY
- Dayglo® 122-9655: Green dye resin composition from Dayglo Corp., Cleveland, OH
- Dayglo® 122-9736: Green dye resin composition from Dayglo Corp., Cleveland, OH
- Dayglo® 122-10316: Blue dye resin composition from Dayglo Corp., Cleveland, OH
- Dayglo® 122-10321: Blue dye resin composition from Dayglo Corp., Cleveland, OH
- Cobratec® CBT: A 50/50 mixture of 4- and 5-substituted isomers of carboxybenzotriazole from Specialties Group Inc., Cincinnati, OH
- Dowanol PM®: Propyleneglycol monomethyl ether
- Amphoteric Polymer: Polymer formed from 40% N-t-octyl acrylamide, 34% methyl methacrylate, 16% acrylic acid, 6% hydroxypropyl methacrylate, and 4% t-butyl aminoethyl methacrylate; molecular weight about 50,000
- PVP-K-120: Polyvinylpyrrolidine from ISP Corp., Bound Brook, NJ
- PVP-K-90: Polyvinylpyrrolidine from ISP Corp., Bound Brook, NJ

### Preparation of Low MW Amic Acid Copolymers Amic Acid #1 Preparation

The amic acid containing binder #1 used in Examples 1 to 11 was prepared from a copolymer of itaconic anhydride/itaconic acid/butyl acrylate/butyl methacrylate/styrene, 23/4/38/20/15, weight average molecular weight of 4,000, containing the following components:

| Components | Parts by Weight |
|---|---|
| Copolymer at 90% solids in xylene | 48.24 |
| Ethyl acetate | 35.15 |
| Methanol | 10.00 |
| n-butylamine | 6.61 |

The butylamine was dissolved in the methanol and added over 1.5 hours to the stirred copolymer solution after the ethyl acetate was added. Stirring was continued for 2 hours.

### Amic Acid #2 Preparation

The amic acid containing binder #2 used in Example 1A was prepared from a copolymer of itaconic anhydride/itaconic acid/butyl acrylate/butyl methacrylate/styrene, 23/4/38/20/15, weight average molecular weight of 4,000 containing the following components:

| Components | Parts by Weight |
|---|---|
| Copolymer at 65% solids in a mixture of ethyl acetate and xylene | 64.27 |
| Ethyl acetate | 17.23 |
| Methanol | 9.97 |
| n-butylamine | 8.53 |

The butylamine was dissolved in the methanol and was added to the stirred polymer solution in ethyl acetate over 1.5 hours. Stirring was continued for 2 hours.

### Permanent Coating Formation

The coating solutions were converted to dry film product using a Pilot Machine Coater. The liquid compositions were coated on a 25 µm (1 mil) polyethylene support using a 0.25 mm (10 mil) doctor knife to give approximately a 51 µm (2 mil) thick dried film composition. A three-zone dryer with each zone 4.6 m (15 feet) long and with dryer temperatures of 50°C, 98°C and 115°C and a line speed of 6.1 m (20 feet) per minute was used. The coating compositions and test results for Examples 1 to 11 and Comparative Examples 1A and 2A are summarized in Tables I to VI.

### Example 1 (Comparative Example 1A)

Example 1 shows the advantage of using a blocked polyisocyanate as compared to a melamine thermal crosslinker in the coating composition. Both Examples 1 and 1A were cured at conditions to yield similar solvent resistance and similar flexibility.

**TABLE I**

| Component | Example 1 | Example 1A |
|---|---|---|
| | (% by weight) | (% by weight) |
| Ethyl Acetate | 22.60 | 37.22 |
| Methanol | 10.36 | 10.61 |
| Dowanol PM | 5.35 | ---- |
| Ebecryl® 3704 (75% solids in ethyl acetate) | 10.59 | 8.92 |
| Ebecryl® 6700 (75% solids in ethyl acetate) | 14.10 | 11.86 |
| Amic Acid #1 (47.7% solids) | 13.44 | ---- |
| Amic Acid #2 (50.0% solids) | ---- | 12.09 |
| Cobratec® CBT | 0.09 | ---- |
| 3 MT | ---- | 0.08 |
| o-C1 HABI | 0.28 | 0.24 |
| EMK | 0.05 | 0.04 |
| Irganox® 1010 | 0.23 | 0.24 |
| Benzophenone | 1.88 | 1.76 |
| PVP-K-90 | 1.51 | 1.56 |
| Blocked Isocyanate #1 | 7.20 | ---- |
| Cymel® 1158 (80% in butanol) | ---- | 4.46 |
| Carboxylated Copolymer #1 | 10.90 | 9.69 |
| DayGlo® 122-9655 | 1.41 | ---- |
| DayGlo® 122-9736 | ---- | 1.56 |

### Property

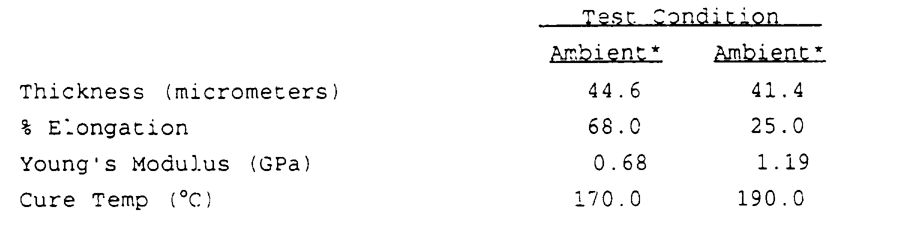

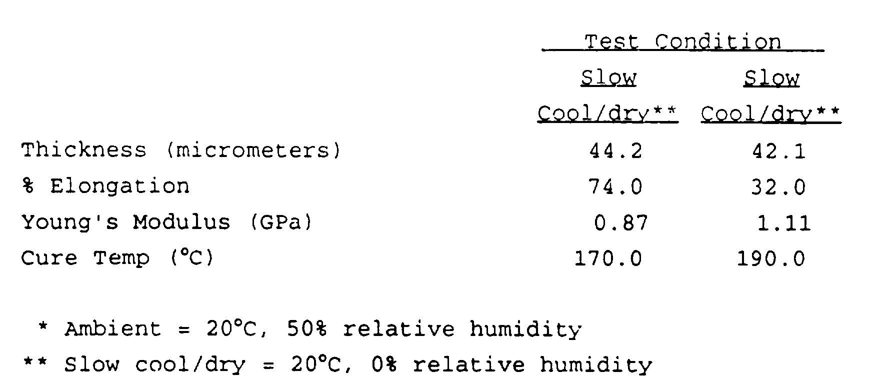

### Chemical Resistance

| Substrate: Mechanically brush scrubbed Pyralux® LF9110¹ | | |
|---|---|---|
| Methylene Chloride | Pass (10 minutes) | Pass (10 minutes) |
| 10% NaOH | Pass (20 minutes) | Pass (20 minutes) |
| 10% H₂SO₄ | Pass (20 minutes) | Pass (20 minutes) |
| Boiling IPA/water | Pass (15 minutes) | Pass (15 minutes) |

| | | |
|---|---|---|
| ¹ Pyralux® LF-9110 is a laminate of 25 µm (1 mil) Kapton® polyimide film, 25 µm (1 mil) acrylic adhesive and 305 g/m² (1 oz/ft²) copper foil, commercially available from E. I. duPont de Nemours & Co. | | |

### Example 2 (Comparative Example 2A)

Example 2 shows the advantage of using a low MW amic acid cobinder to achieve flexibility and adhesion as compared to Example 2A that contains no amic acid cobinder.

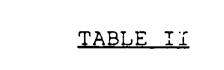

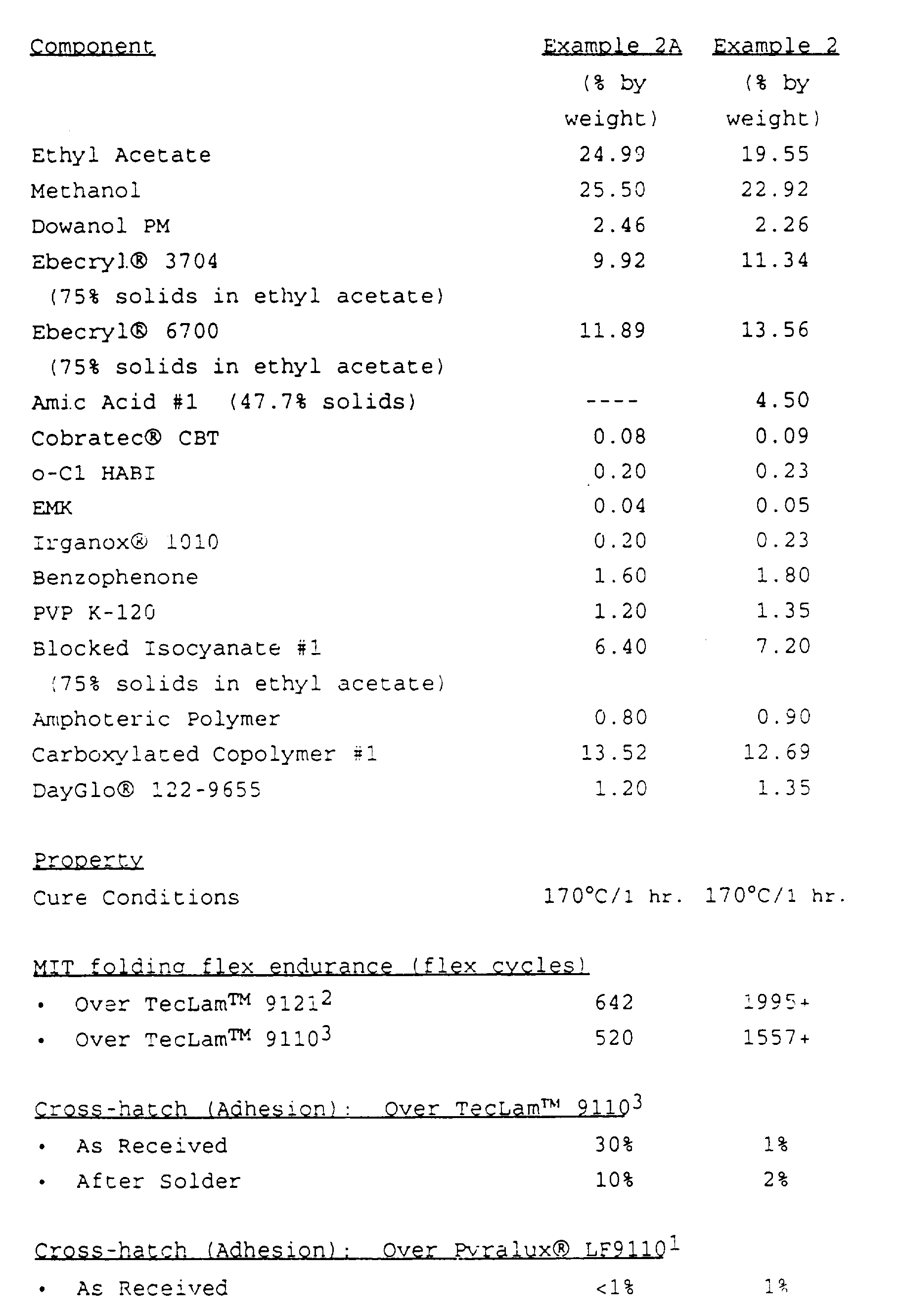

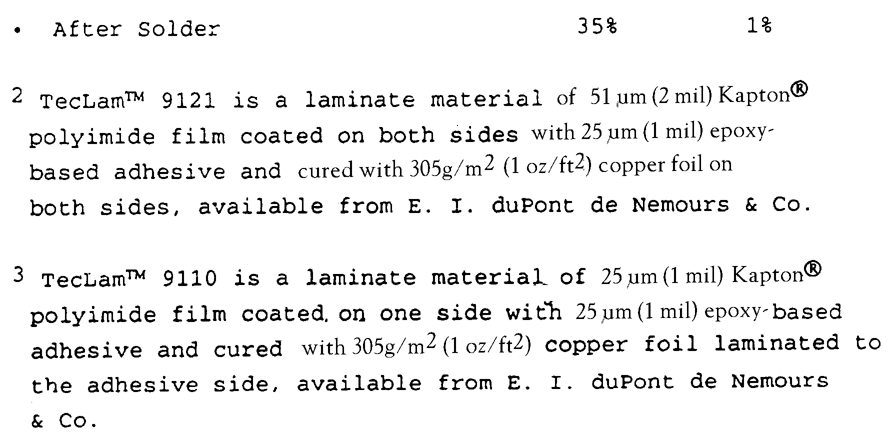

### Examples 3 to 5

Examples 3 to 5 show the properties obtained using different high molecular weight acrylic cobinders in the coating compositions.

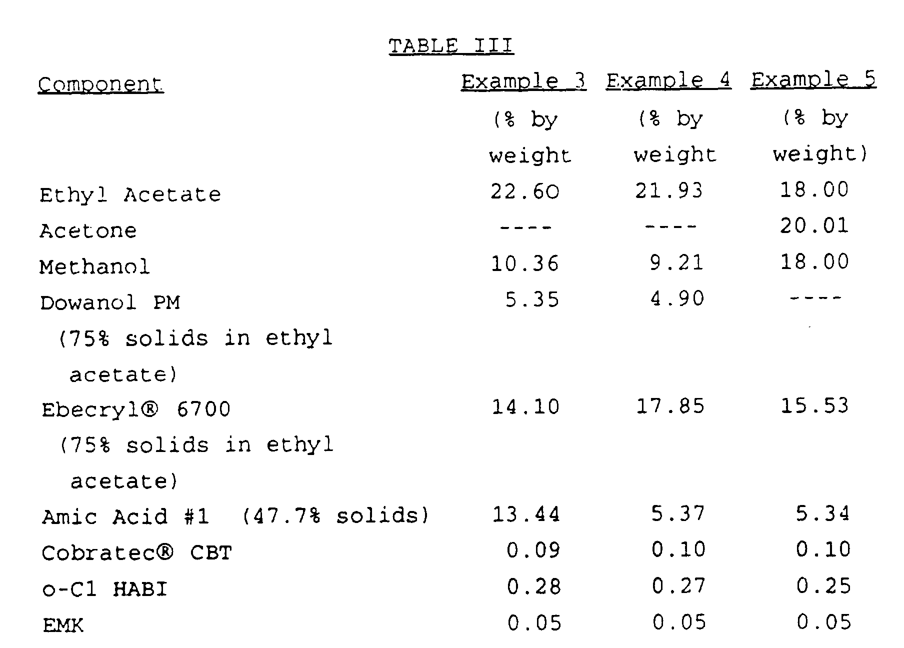

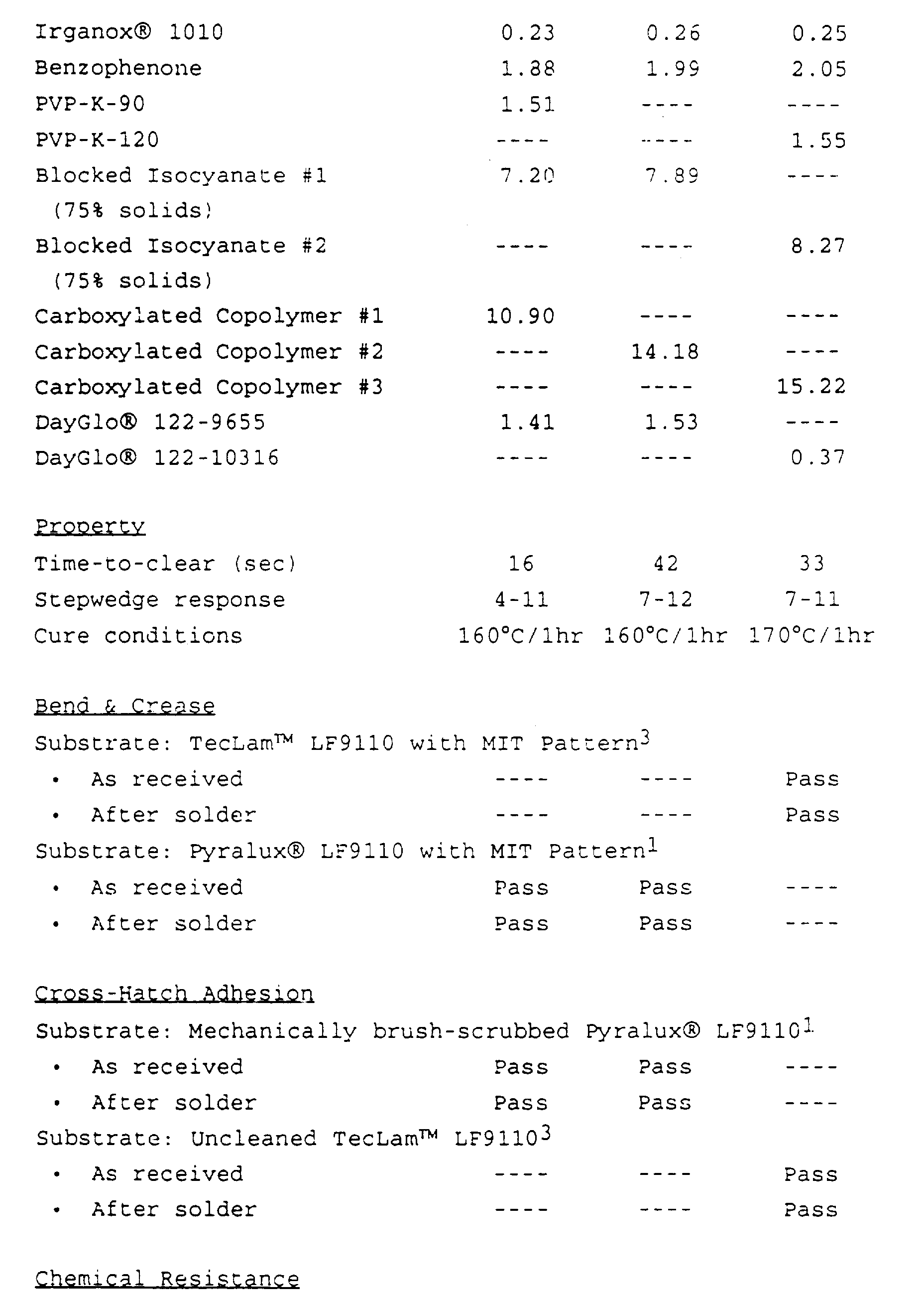

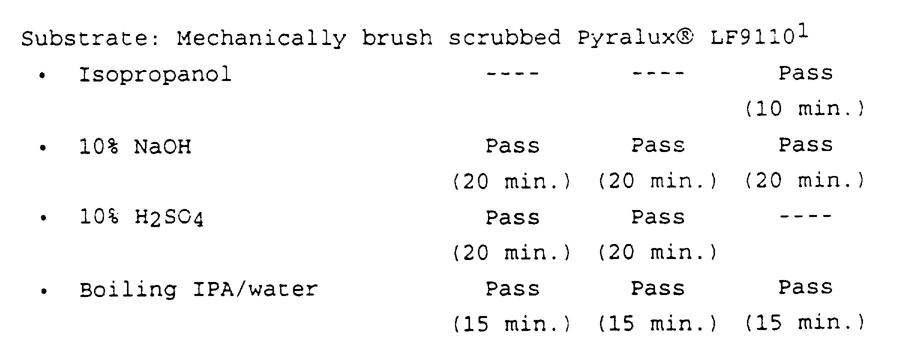

### Examples 6 to 8

Examples 6 to 8 show the properties obtained using different urethane acrylates in the coating compositions.

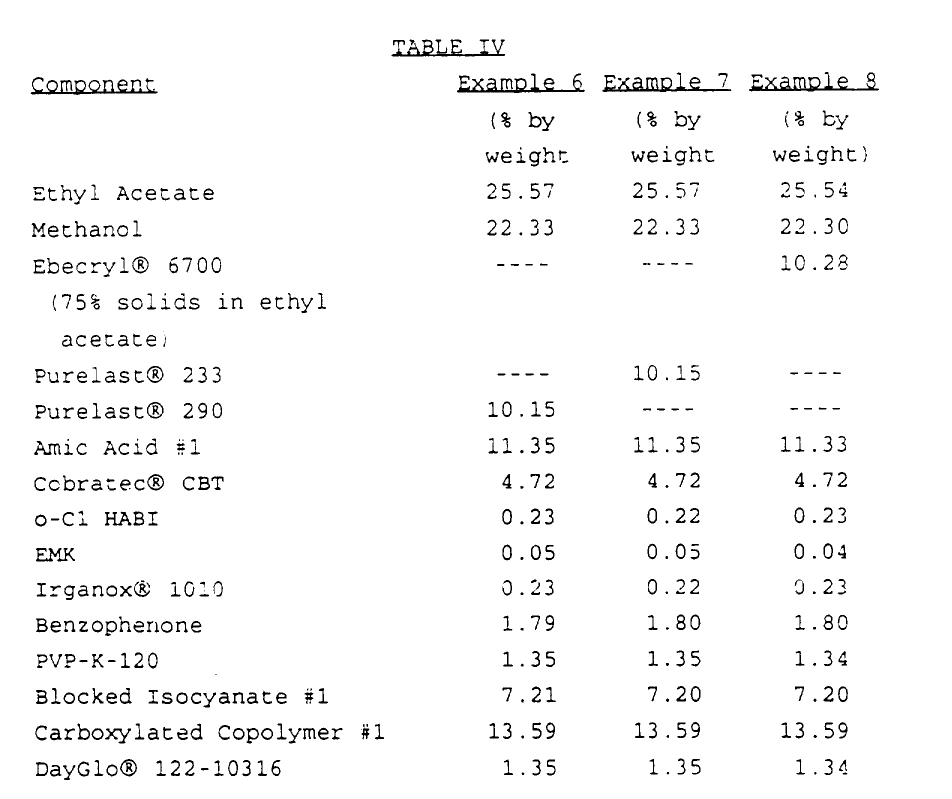

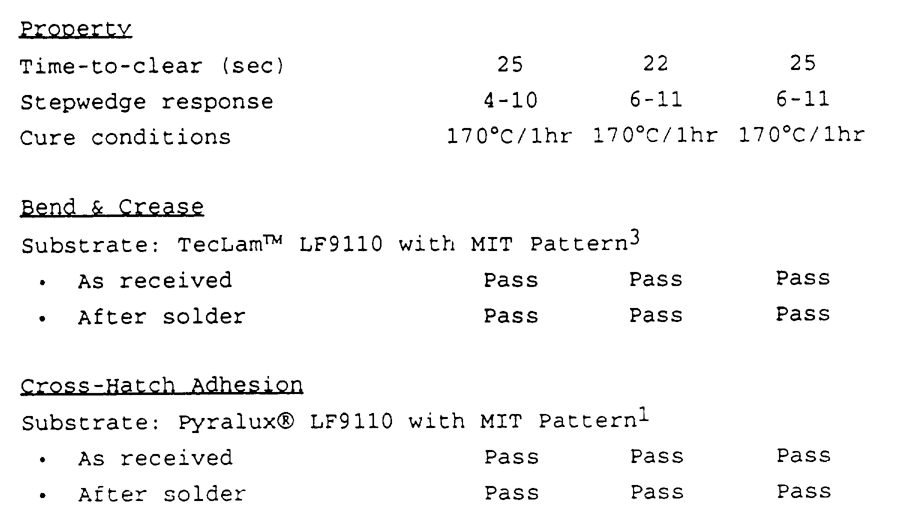

### Examples 9 and 10

Examples 9 and 10 show the results of using different blocked polyisocyanate crosslinking agents in the coating compositions.

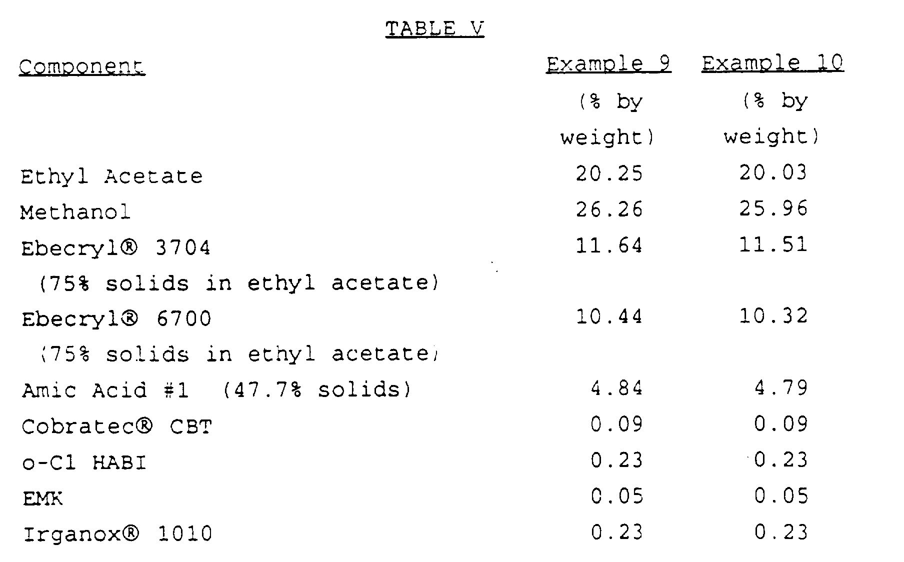

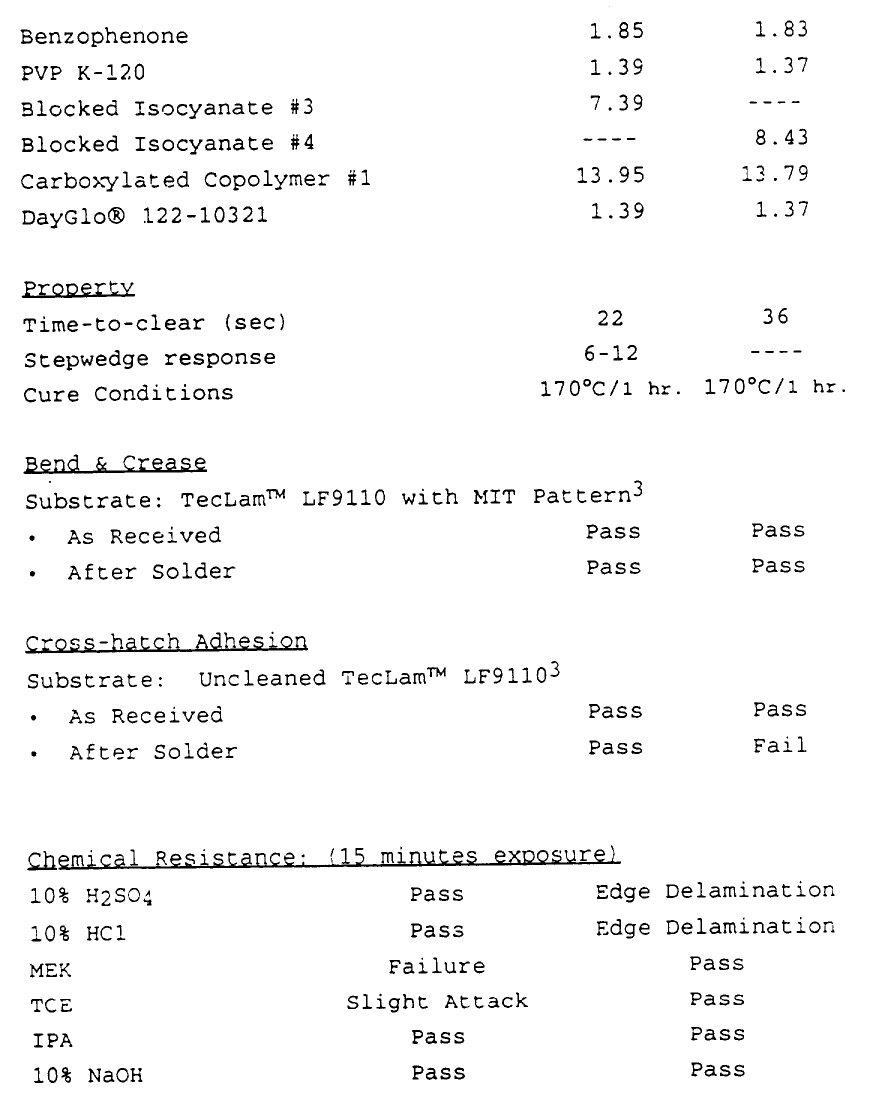

### Example 11

Example 11 represents a preferred coating composition of the invention:

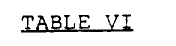

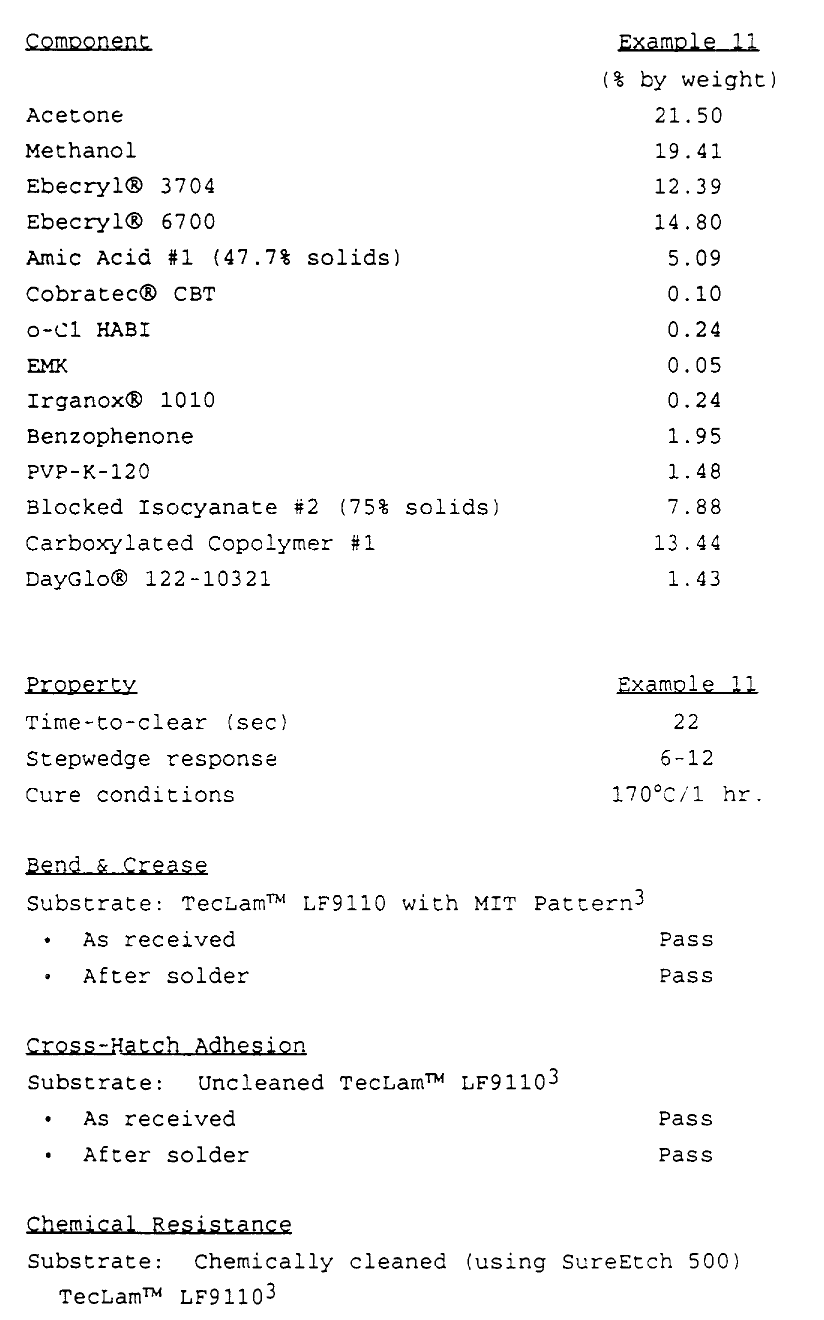

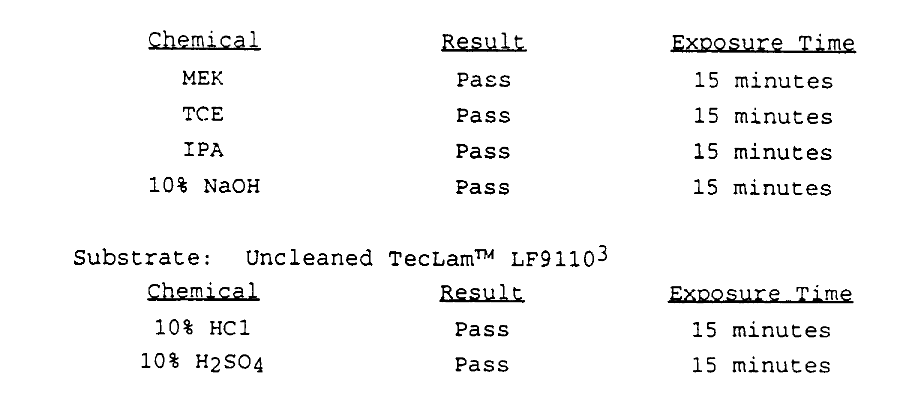

## Claims

1. An aqueous processable, photopolymerizable, permanent coating composition, that is both pliable and withstands molten solder after cure, which comprises:
a) a cobinder system comprising an admixture of at least one low molecular weight copolymer binder having a molecular weight in the range of from 2,000 to 10,000, which is the reaction product of a primary amine with a copolymer formed from at least one ethylenically unsaturated dicarboxylic acid anhydride and at least one ethylenically unsaturated comonomer and containing at least one structural unit A and at least one additional structural unit B₁ or B₂ containing carboxyl groups; and at least one high molecular weight carboxylic acid-containing copolymer binder having a molecular weight in the range of from 50,000 to 500,000, wherein:
(I) 5 to 50 percent by weight of said low molecular weight copolymer binder is formed from at least one structural unit B₁, B₂ or combinations thereof containing carboxyl groups,
(II) 50 to 95 percent by weight of said low molecular weight copolymer binder is formed from structural unit A, wherein A is different from structural units B₁ and B₂,
(III) A, B₁ and B₂ have the structures: 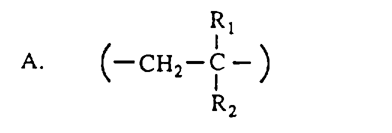 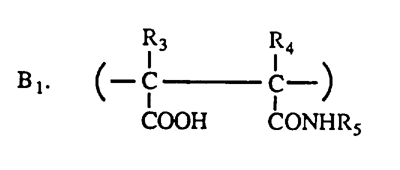 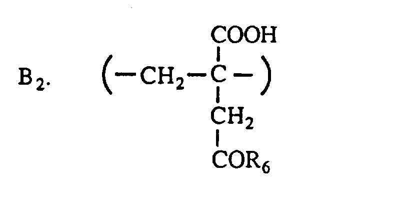 wherein:
R₁ is H, alkyl, phenyl or aryl;
R₂ is H, CH₃, phenyl, aryl, -COOR₇, -CONR₈R₉ or -CN;
R₃ and R₄ independently are H or alkyl;
R₅ is alkyl or aryl which is unsubstituted or substituted with primary amino, secondary amino, tertiary amino, hydroxy or ether groups or mixtures thereof;
R₆ is -OH or -NHR5; and
R₇, R₈ and R₉ independently are H, alkyl or aryl, which is unsubstituted or substituted with one or more hydroxy, ester, keto, ether or thioether groups;
b) an acrylated urethane monomeric component;
c) a photoinitiator or a photoinitiator system; and
d) a blocked polyisocyanate crosslinking agent.

2. The photopolymerizable permanent coating composition of Claim 1 wherein the ethylenically unsaturated dicarboxylic acid anhydride is selected from the group consisting of maleic acid anhydride, itaconic acid anhydride and citraconic acid anhydride.

3. The photopolymerizable permanent coating composition of Claim 1 wherein the primary amine is selected from the group consisting of a primary aliphatic or aromatic amine which can be unsubstituted or substituted with primary amino, secondary amino, tertiary amino, hydroxy, ester, keto, ether or thioether groups.

4. The photopolymerizable permanent coating composition of Claim 1 wherein the ethylenically unsaturated comonomer is selected from the group consisting of styrene, (meth)acrylic acid, (meth)acrylamides or (meth)acrylates.

5. The photopolymerizable permanent coating composition of Claim 1 wherein the low molecular weight copolymer binder comprises the reaction product of n-butyl amine with a copolymer of styrene, butyl methacrylate, butyl acrylate and itaconic acid anhydride.

6. The photopolymerizable permanent coating composition of Claim 1 wherein the high molecular weight carboxylic acid-containing copolymer comprises monomer units of the formula 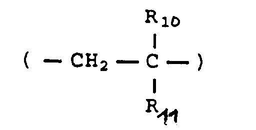 wherein R₁₀ is H, alkyl, -CN, phenyl or alkylphenyl; R₁₁ is phenyl, alkylphenyl or -CO₂R₁₂ and R₁₂ is H or alkyl wherein alkyl contains from 1 to 4 carbon atoms.

7. The photopolymerizable permanent coating composition of Claim 6 wherein the high molecular weight carboxylic acid-containing copolymer comprises a terpolymer of ethyl acrylate, methyl methacrylate and acrylic acid.

8. The photopolymerizable permanent coating composition of Claim 6 wherein the high molecular weight carboxylic acid-containing copolymer comprises a terpolymer of methyl methacrylate, butyl acrylate and methacrylic acid.

9. The photopolymerizable permanent coating composition of Claim 6 wherein the high molecular weight carboxylic acid-containing copolymer comprises a copolymer of styrene and maleic anhydride, acid, ester, half-ester, or half-amide.

10. The photopolymerizable permanent coating composition of Claim 1 wherein the acrylated urethane monomeric component has the structure: 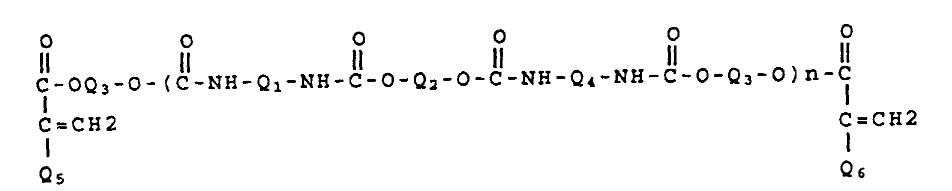 wherein n is at least one; Q₁ and Q₄ are aromatic groups which are unsubstituted or substituted by lower alkyl groups and which can contain a lower alkylene group as a connecting member; Q₂ and Q₃ are independently polyoxyalkylene containing 1 to 10 carbon atoms; and Q₅ and Q₆ are independently alkyl of 1 to 3 carbon atoms or H.

11. The photopolymerizable permanent coating composition of Claim 10 wherein the acrylated urethane monomeric component is a urethane diacrylate comprising the reaction product of toluene diisocyanate with a polyol and the end isocyanate groups end-capped with hydroxyethyl acrylate.

12. The photopolymerizable permanent coating composition of Claim 10 wherein the acrylated urethane monomeric component is a urethane triacrylate comprising the reaction product of toluene diisocyanate with a polyol and the end isocyanate groups end-capped with hydroxyethyl acrylate.

13. The photopolymerizable permanent coating composition of Claim 1 wherein the acrylated urethane monomeric component is a urethane diacrylate or triacrylate.

14. The photopolymerizable permanent coating composition of Claim 1 wherein the acrylated urethane monomeric component is a urethane diacrylate or triacrylate containing carboxylic acid groups.

15. The photopolymerizable permanent coating composition of Claim 1 wherein the monomeric component further comprises a comonomer.

16. The photopolymerizable permanent coating composition of Claim 15 wherein the comonomer is selected from the group consisting of hydroxy C1-C10-alkyl acrylate, hexamethylene glycol diacrylate, triethylene glycol diacrylate, tripropylene glycol diacrylate, pentaerythritol triacrylate, trimethylolpropane triacrylate, polyoxyethylated trimethylolpropane triacrylate, di-(3-acryloxy-2-hydroxypropyl) ether of bisphenol-A, di-(3-acryloxy-2-hydroxypropyl) ether of tetrabromo-bisphenol-A, and methacrylate analogues thereof.

17. The photopolymerizable permanent coating composition of Claim 1 wherein the blocked polyisocyanate crosslinking agent comprises an aliphatic, cycloaliphatic, aromatic or arylaliphatic di, tri or tetraisocyanate whose isocyanate groups are blocked by betacarbonyl compounds, hydroxamates, triazoles, imidazoles, tetrahydropyrimidines, lactams, ketoximes, oximes, low molecular weight alcohols, phenols or thiophenols.

18. The photopolymerizable permanent coating composition of Claim 17 wherein the blocked polyisocyanate comprises the trimer of hexamethylene diisocyanate blocked with methylethyl ketoxime.

19. The photopolymerizable permanent coating composition of Claim 17 wherein the blocked polyisocyanate comprises isophorone diisocyanate blocked with methyl ethyl ketoxime.

20. A flexible printed circuit comprising:
i) a flexible substrate;
ii) an electrically conductive circuit pattern on at least one side of said flexible substrate; and
iii) a permanent coating composition applied over said electrically conductive circuit pattern to form the outermost layer, which coating composition is cured, wherein said coating composition is as defined in claim 1.

21. A rigid, printed circuit comprising a rigid substrate, an electrically conductive circuit pattern on at least one side of said rigid substrate and an outermost layer of the cured permanent coating composition of Claim 1 applied over said electrically conductive circuit pattern.

22. A printed circuit comprising both rigid and flexible substrates, an electrically conductive circuit pattern on at least one side of said rigid-flexible substrate and an outermost layer of the cured permanent coating composition of Claim 1 applied over said electrically conductive circuit pattern.

23. The printed circuit of Claim 22 wherein said rigid substrate is adjacent to said outermost layer of cured permanent coating.

24. The printed circuit of Claim 22 wherein said flexible substrate is adjacent to said outermost layer of cured permanent coating.

## Patentansprüche

1. Wäßrig-verarbeitbare, photopolymerisierbare, permanente Beschichtungszusammensetzung, die sowohl geschmeidig ist, als auch nach dem Härten gegenüber geschmolzenem Lötmittel beständig ist, umfassend:
a) ein Co-Bindemittelsystem, umfassend eine Mischung von wenigstens einem niedermolekularen Copolymer-Bindemittel einer Molmasse im Bereich von 2000 bis 10 000, welches das Reaktionsprodukt eines primären Amins mit einem Copolymer ist, das aus wenigstens einem ethylenisch ungesättigten Dicarbonsäureanhydrid und wenigstens einem ethylenisch ungesättigten Comonomer gebildet wird, und wenigstens eine Struktureinheit A und wenigstens eine zusätzliche Struktureinheit B₁ oder B₂ enthält, die Carboxylgruppen enthält; und wenigstens einem hochmolekularen, carbonsäureenthaltenden Copolymer-Bindemittel mit einer Molmasse im Bereich von 50 000 bis 500 000, worin:
(I) 5 bis 50 Gew.-% des niedermolekularen Copolymer-Bindemittels aus wenigstens einer Struktureinheit B₁, B₂ oder Kombinationen derselben, die Carboxylgruppen enthalten, gebildet wird,
(II) 50 bis 95 Gew.-% des niedermolekularen Copolymer-Bindemittels aus der Struktureinheit A gebildet werden, worin-A von den Struktureinheiten B₁ und B₂ verschieden ist,
(III) A, B₁ und B₂ die Strukturen: 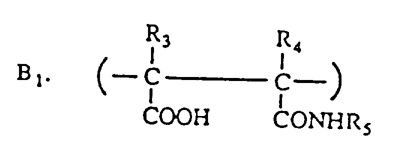 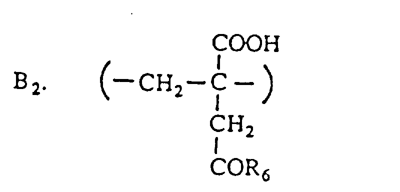 haben, worin
R₁ H, Alkyl, Phenyl oder Aryl ist;
R₂ H, CH₃, Phenyl, Aryl, -COOR₇, -CONR₈R₉ oder -CN ist;
R₃ und R₄ unabhängig voneinander H oder Alkyl sind;
R₅ Alkyl oder Aryl ist, das unsubstituiert ist oder mit primären Amino-, sekundären Amino-, tertiären Amino-, Hydroxy- oder Ethergruppen oder Mischungen derselben substituiert ist;
R₆ -OH oder -NHR₅ ist, und
R₇, R₈ und R₉ unabhängig voneinander H, Alkyl oder Aryl sind, das unsubstituiert ist oder mit einer oder mehreren Hydroxy-, Ester-, Keto-, Ether- oder Thioether-Gruppe(n) substituiert ist,
b) eine monomere acrylierte Urethan-Komponente;
c) einen Photoinitiator oder ein Photoinitiatorsystem, und
d) ein geblocktes Polyisocyanat-Vernetzungsmittel.

2. Photopolymerisierbare, permanente, Beschichtungszusammensetzung gemäß Anspruch 1, worin das ethylenisch ungesättigte Dicarbonsäureanhydrid aus der Gruppe ausgewählt ist, die aus Maleinsäureanhydrid, Itaconsäureanhydrid und Citraconsäureanhydrid besteht.

3. Photopolymerisierbare, permanente, Beschichtungszusammensetzung gemäß Anspruch 1, worin das primäre Amin aus der Gruppe ausgewählt ist, die aus einem primären, aliphatischen oder aromatischen Amin ausgewählt ist, das unsubstituiert sein kann oder mit primären Amino-, sekundären Amino-, tertiären Amino-, Hydroxy-, Ester-, Keto-, Ether- oder Thioether-Gruppen substituiert sein kann.

4. Photopolymerisierbare, permanente, Beschichtungszusammensetzung gemäß Anspruch 1, worin das ethylenisch ungesättigte Comonomer aus der Gruppe ausgewählt ist, die aus Styrol, (Meth)acrylsäure, (Meth)acrylamiden oder (Meth)acrylaten besteht.

5. Photopolymerisierbare, permanente, Beschichtungszusammensetzung gemäß Anspruch 1, worin das niedermolekulare Copolymer-Bindemittel das Reaktionsprodukt von n-Butylamin mit einem Copolymer von Styrol, Butylmethacrylat, Butylacrylat und Itaconsäureanhydrid umfaßt.

6. Photopolymerisierbare, permanente, Beschichtungszusammensetzung gemäß Anspruch 1, worin das hochmolekulare, carbonsäureenthaltende Copolymer Monomereinheiten der Formel: 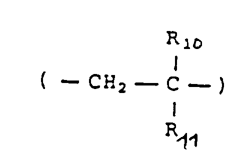 umfaßt, worin R₁₀ H, Alkyl, -CN, Phenyl oder Alkylphenyl ist; R₁₁ Phenyl, Alkylphenyl oder -CO₂R₁₂ ist und R₁₂ H oder Alkyl ist, worin Alkyl 1 bis 4 Kohlenstoffatome enthält.

7. Photopolymerisierbare, permanente, Beschichtungszusammensetzung gemäß Anspruch 6, worin das hochmolekulare, carbonsäureenthaltende Copolymer ein Terpolymer von Ethylacrylat, Methylmethacrylat und Acrylsäure umfaßt.

8. Photopolymerisierbare, permanente, Beschichtungszusammensetzung gemäß Anspruch 6, worin das hochmolekulare, carbonsäureenthaltende Copolymer ein Terpolymer von Methylmethacrylat, Butylacrylat und Methacrylsäure umfaßt.

9. Photopolymerisierbare, permanente, Beschichtungszusammensetzung gemäß Anspruch 6, worin das hochmolekulare, carbonsäureenthaltende Copolymer ein Copolymer von Styrol und Maleinsäureanhydrid, -säure,-ester, -halbester oder -halbamid umfaßt.

10. Photopolymerisierbare, permanente, Beschichtungszusammensetzung gemäß Anspruch 1, worin die acrylierte, monomere Urethan-Komponente die Struktur: 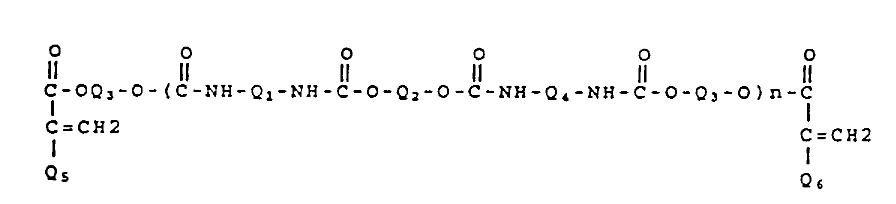 hat, worin n wenigstens 1 ist; Q₁ und Q₄ aromatische Gruppen sind, die nichtsubstituiert sind oder durch Niederalkylgruppen substituiert sind, und die eine Niederalkylgruppe als Verbindungsglied enthalten können; Q₂ und Q₃ unabhängig voneinander Polyoxyalkylen sind, das 1 bis 10 Kohlenstoffatome enthält, und Q₅ und Q₆ unabhängig voneinander Alkyl mit 1 bis 3 Kohlenstoffatomen oder H sind.

11. Photopolymerisierbare, permanente, Beschichtungszusammensetzung gemäß Anspruch 10, worin die acrylierte, monomere Urethan-Komponente ein Urethandiacrylat ist, das das Reaktionsprodukt von Toluoldiisocyanat mit einem Polyol umfaßt, und worin die Isocyanat-Endgruppen mit Hydroxylacrylat endverkappt sind.

12. Photopolymerisierbare, permanente, Beschichtungszusammensetzung gemäß Anspruch 10, worin die acrylierte, monomere Urethan-Komponente ein Urethantriacrylat ist, das das Reaktionsprodukt von Toluoldiisocyanat mit einem Polyol umfaßt, und worin die Isocyanat-Endgruppen mit Hydroxylacrylat endverkappt sind.

13. Photopolymerisierbare, permanente, Beschichtungszusammensetzung gemäß Anspruch 1, worin die acrylierte, monomere Urethan-Komponente ein Urethandiacrylat oder -triacrylat ist.

14. Photopolymerisierbare, permanente, Beschichtungszusammensetzung gemäß Anspruch 1, worin die acrylierte, monomere Urethan-Komponente ein Urethandiacrylat oder -triacrylat ist, das Carbonsäure-Gruppen enthält.

15. Photopolymerisierbare, permanente, Beschichtungszusammensetzung gemäß Anspruch 1, worin die monomere Komponente weiterhin ein Comonomer umfaßt.

16. Photopolymerisierbare, permanente, Beschichtungszusammensetzung gemäß Anspruch 1, worin das Comonomer aus der Gruppe ausgewählt ist, die aus Hydroxy-C₁-C₁₀-alkylacrylat, Hexamethylenglycoldiacrylat, Triethylenglycoldiacrylat, Tripropylenglycoldiacrylat, Pentaerythrittriacrylat, Trimethylolpropantriacrylat, polyoxyethyliertem Trimethylolpropantriacrylat, Di-(3-acryloxy-2-hydroxypropyl)ether von Bisphenol-A, Di-(3-acryloxy-2-hydroxypropyl)ether von Tetrabrombisphenol-A und MethacrylatAnalogen derselben besteht.

17. Photopolymerisierbare, permanente, Beschichtungszusammensetzung gemäß Anspruch 1, worin das geblockte Polyisocyanat-Vernetzungsmittel ein aliphatisches, cycloaliphatisches, aromatisches oder arylaliphatisches Di-, Tri-oder Tetraisocyanat umfaßt, dessen Isocyanat-Gruppen durch β-Carbonyl-Verbindungen, Hydroxamate, Triazole, Imidazole, Tetrahydropyrimidine, Lactame, Ketoxime, Oxime, niedermolekulare Alkohole, Phenole oder Thiophenole geblockt sind.

18. Photopolymerisierbare, permanente, Beschichtungszusammensetzung gemäß Anspruch 17, worin das geblockte Polyisocyanat das Trimer von Hexamethylendiisocyanat, geblockt mit Methylethylketoxim, umfaßt.

19. Photopolymerisierbare, permanente,-Beschichtungszusammensetzung gemäß Anspruch 17, worin das geblockte Polyisocyanat Isophorondiisocyanat, geblockt mit Methylethylketoxim, umfaßt.

20. Flexible, gedruckte Schaltung, umfassend:
i) ein flexibles Substrat,
ii) eine elektrisch leitfähige Schaltkreisstruktur auf wenigstens einer Seite des flexiblen Substrats; und
iii) eine permanente Beschichtungszusammensetzung, die über die elektrisch leitfähige Schaltkreisstruktur aufgetragen wird, um die äußerste Schicht zu bilden, wobei die Beschichtungszusammensetzung gehärtet wird, worin die Beschichtungszusammensetzung gemäß Anspruch 1 definiert ist.

21. Steife, gedruckte Schaltung, umfassend ein steifes Substrat, eine elektrisch leitfähige Schaltkreisstruktur auf wenigstens einer Seite des steifen Substrats, und eine äußerste Schicht der gehärteten, permanenten Beschichtungszusammensetzung gemäß Anspruch 1, die über die elektrisch leitfähige Schaltkreisstruktur aufgetragen ist.

22. Gedruckte Schaltung, umfassend sowohl steife als auch flexible Substrate, eine elektrisch leitfähige Schaltkreisstruktur auf wenigstens einer Seite des steifenflexiblen Substrats und eine äußerste Schicht von gehärteter, permanenter Beschichtungszusammensetzung gemäß Anspruch 1, die über die elektrisch leitfähige Schaltkreisstruktur aufgetragen ist.

23. Gedruckte Schaltung gemäß Anspruch 22, worin das steife Substrat zu der äußersten Schicht von gehärteter, permanenter Beschichtung benachbart vorliegt.

24. Gedruckte Schaltung gemäß Anspruch 22, worin das flexible Substrat zu der äußersten Schicht von gehärteter, permanenter Beschichtung benachbart vorliegt.

## Revendications

1. Une composition de revêtement permanente, photopolymérisable, susceptible d'être développée en milieu aqueux, qui est à la fois souple et qui supporte la soudure fondue après cuisson, qui comprend:
a) un système coliant comprenant un mélange d'au moins un liant copolymère de faible poids moléculaire ayant un poids moléculaire compris entre 2000 et 10 000, qui est le produit de la réaction d'une amine primaire avec un copolymère formé d'au moins un anhydride d'acide dicarboxylique à insaturation éthylénique et d'au moins un comonomère à insaturation éthylénique et contenant au moins un motif structural A et au moins un autre motif structural B₁ ou B₂ contenant des groupes carboxyle; et au moins un liant copolymère contenant des fonctions acides carboxyliques de poids moléculaire élevé ayant un poids moléculaire compris entre 50 000 et 500 000, dans lequel:
(I) 5 à 50 % en poids dudit liant copolymère de faible poids moléculaire est formé d'au moins un motif structural B₁, B₂ ou leur combinaison contenant des groupes carboxyle,
(II) 50 à 95 % en poids dudit liant copolymère de faible poids moléculaire est formé de motifs structuraux A où A est différent des motifs structuraux B₁ et B₂,
(III) A, B₁ et B₂ répondent aux formules développées: 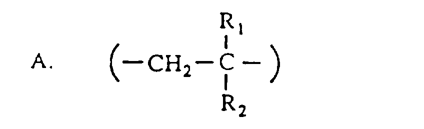 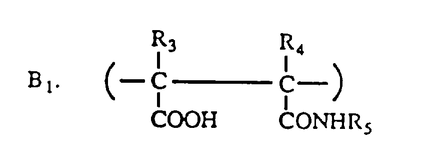 où:
R₁ est H, un alkyle, un phényle ou un aryle;
R₂ est H, un CH₃, un phényle, un aryle, -COOR₇, -CONR₈R₉ ou -CN;
R₃ et R₄ sont indépendamment des H ou des alkyles;
R₅ est un alkyle ou un aryle qui est non substitué ou substitué par des groupes amine primaire, amine secondaire, amine tertiaire, hydroxy ou éther, ou leurs mélanges;
R₆ est -OH ou -NHR₅; et
R₇, R₈ et R₉ sont indépendamment des H, des alkyles ou aryles, qui sont non substitués ou substitués par un ou plusieurs groupes hydroxy, ester, céto, éther ou thioéther,
b) un constituant monomère uréthane acrylé;
c) un photoinitiateur ou un système photoinitiateur; et
d) un agent de réticulation polyisocyanate bloqué.

2. La composition de revêtement permanente photopolymérisable selon la revendication 1, dans laquelle l'anhydride d'acide dicarboxylique à insaturation éthylénique est choisi dans le groupe consistant en anhydride de l'acide maléique, anhydride de l'acide itaconique et anhydride de l'acide citraconique.

3. La composition de revêtement permanente photopolymérisable selon la revendication 1, dans laquelle l'amine primaire est choisie dans le groupe consistant en amine aliphatique ou aromatique primaire qui peut être non substituée ou substituée par des groupes amine primaire, amine secondaire, amine tertiaire, hydroxy, ester, céto, éther ou thioéther.

4. La composition de revêtement permanente photopolymérisable selon la revendication 1, dans laquelle le comonomère à insaturation éthylénique est choisi dans le groupe consistant en styrène, acide (meth)acrylique, les (meth)acrylamides ou les (meth)acrylates.

5. La composition de revêtement permanente photopolymérisable selon la revendication 1, dans laquelle le liant copolymère de faible poids moléculaire comprend le produit de la réaction de la n-butylamine avec un copolymère de styrène, de méthacrylate de butyle, d'acrylate de butyle et d'anhydride de l'acide itaconique.

6. La composition de revêtement permanente photopolymérisable selon la revendication 1, dans laquelle le copolymère contenant l'acide carboxylique de poids moléculaire élevé comprend les motifs monomères de formule: 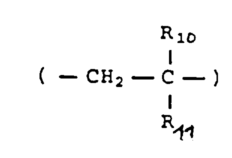 dans laquelle:
R₁₀ est un H, un alkyle, un -CN, un phényle ou un alkylphényle;
R₁₁ est un phényle, un alkylphényle ou un -CO₂R₁₂; et
R₁₂ est un H ou un alkyle comportant 1 à 4 atomes de carbone.

7. La composition de revêtement permanente photopolymérisable selon la revendication 6, dans laquelle le copolymère contenant l'acide carboxylique de poids moléculaire élevé comprend un terpolymère d'acrylate d'éthyle, de méthacrylate de méthyle et d'acide acrylique.

8. La composition de revêtement permanente photopolymérisable selon la revendication 6, dans laquelle le copolymère contenant l'acide carboxylique de poids moléculaire élevé comprend un terpolymère de methacrylate de méthyle, d'acrylate de butyle et d'acide méthacrylique.

9. La composition de revêtement permanente photopolymérisable selon la revendication 6, dans laquelle le copolymère contenant l'acide carboxylique de poids moléculaire élevé comprend un copolymère de styrène et d'anhydride, acide, ester, hémi-ester ou hémi-amide maléiques.

10. La composition de revêtement permanente photopolymérisable selon la revendication 1, dans laquelle le constituant monomère uréthane acrylé présente la formule développée: 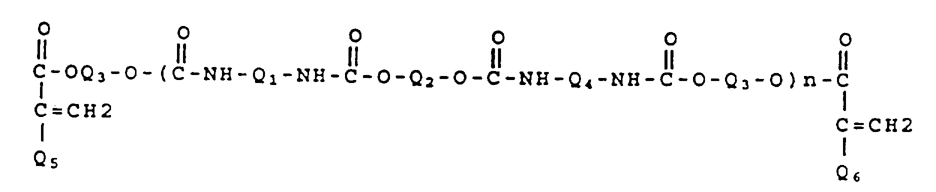 dans laquelle:
n est égal à au moins un;
Q₁ et Q₄ sont des groupes aromatiques qui sont non substitués ou substitués par des alkyles inférieurs et qui peuvent comporter un groupe alkylène inférieur en tant que élément de liaison;
Q₂ et Q₃ sont indépendamment des polyoxyalkylènes contenant de 1 à 10 atomes de carbone; et
Q₅ et Q₆ sont indépendamment des alkyles comportant 1 à 3 atomes de carbone ou H.

11. La composition de revêtement permanente photopolymérisable selon la revendication 10, dans laquelle le composé monomère uréthane acrylé est un di-acrylate d'uréthane comprenant le produit de la réaction du toluène diisocyanate avec un polyol et dont les groupes isocyanates terminaux sont coiffés d'un groupe hydroxyéthylacrylate.

12. La composition de revêtement permanente photopolymérisable selon la revendication 10, dans laquelle le composant monomère d'uréthane acrylé est un triacrylate d'uréthane comprenant le produit de la réaction du toluène diisocyanate avec un polyol et les groupes terminaux isocyanates étant coiffés du groupe hydroxyéthylacrylate.

13. La composition de revêtement permanente photopolymérisable selon la revendication 1, dans laquelle le constituant monomère uréthane acrylé est un di-acrylate d'uréthane ou un triacrylate d'uréthane.

14. La composition de revêtement permanente photopolymérisable selon la revendication 1, dans laquelle le constituant monomère uréthane acrylé est un di-acrylate ou un triacrylate d'uréthane contenant des groupes acide carboxylique.

15. La composition de revêtement permanente photopolymérisable selon la revendication 1, dans laquelle le constituant monomère comprend en outre un comonomère.

16. La composition de revêtement permanente photopolymérisable selon la revendication 15, dans laquelle le comonomère est choisi dans le groupe consistant en hydroxyacrylate d'alkyle en C₁ à C₁₀, hexaméthylèneglycol diacrylate, triéthylèneglycol diacrylate, tripropylèneglycol diacrylate, pentaérythritol triacrylate, triméthylolpropane triacrylate, triméthylolpropane triacrylate polyoxyéthylé, di-(3-acryloxy-2-hydroxypropyl)éther de bisphénol-A, di-(3-acryloxy-2-hydroxypropyl)éther de tétrabromo-bisphénol-A et les méthacrylates homologues.

17. La composition de revêtement permanente photopolymérisable selon la revendication 1, dans laquelle l'agent de réticulation polyisocyanate bloqué comprend un di-, tri- ou tétraisocyanate aliphatique, cycloaliphatique, aromatique ou arylaliphatique dont les groupes isocyanates sont bloqués par des dérivés bétacarbonylés, des hydroxamates, triazoles, imidazoles, tétrahydropyrimidines, lactames, cétoximes, oximes, alcools de bas poids moléculaire, phénols ou thiophénols.

18. La composition de revêtement permanente photopolymérisable selon la revendication 17, dans laquelle le polyisocyanate bloqué comprend le trimère d'hexaméthylène diisocyanate bloqué par la méthyléthylcétoxime.

19. La composition de revêtement permanente photopolymérisable selon la revendication 17, dans laquelle le polyisocyanate bloqué comprend du diisocyanate d'isophorone bloqué par une méthyléthylcétoxime.

20. Un circuit imprimé souple comprenant:
i) un substrat souple;
ii) un circuit électriquement conducteur sur au moins une des faces dudit substrat souple; et
iii) une composition de revêtement permanente appliquée sur ledit circuit électriquement conducteur pour y former la couche la plus extérieure, ladite composition de revêtement étant cuite et ladite composition de revêtement étant telle que définie dans la revendication 1.

21. Un circuit imprimé rigide comprenant un substrat rigide, un circuit électriquement conducteur sur au moins l'une des faces dudit substrat rigide et une couche extérieure de composition de revêtement permanente cuite selon la revendication 1 appliquée sur ledit circuit électriquement conducteur.

22. Un circuit imprimé comprenant à la fois des substrats rigides et souples, un circuit électriquement conducteur sur au moins une des faces dudit substrat rigide-souple et une couche extérieure de composition de revêtement permanente durcie selon la revendication 1, appliquée sur ledit circuit électriquement conducteur.

23. Le circuit imprimé selon la revendication 22, dans lequel ledit substrat rigide est adjacent à ladite couche extérieure du revêtement permanent durci.

24. Le circuit imprimé selon la revendication 22, dans lequel ledit substrat souple est adjacent à ladite couche extrême de revêtement permanent cuit.
